# EUROPEAN PATENT APPLICATION

(11) **EP 4 328 975 A1**
(43) Date of publication of application: **28.02.2024**
(21) Application number: 23187368.8
(22) Date of filing: 24.07.2023
(51) Int. Cl.: H01L 29/06, H01L 29/10, H01L 29/423, H01L 29/775, H01L 21/336, B82Y 10/00, H01L 29/165, H01L 29/417, H01L 29/78

(54) **SEMICONDUCTOR DEVICES**

(30) Priority: 25.08.2022 KR 20220106707
(71) Applicant: Samsung Electronics Co., Ltd., Suwon-si, Gyeonggi-do 16677 (KR)
(72) Inventor: KIM, Chul, 16677 Suwon-si (KR); JUNG, Yeondo, 16677 Suwon-si (KR); PARK, Gwirim, 16677 Suwon-si, (KR); LEE, Yelin, 16677 Suwon-si (KR); KIM, Kichul, 16677 Suwon-si (KR); CHOI, Kyungin, 16677 Suwon-si (KR)
(74) Representative: Marks & Clerk LLP

(57) **Abstract**

A semiconductor device includes channels (124) spaced apart from each other on a substrate (100) in a vertical direction substantially perpendicular to an upper surface of the substrate (100), a gate structure (290) on the substrate and bordering lower and upper surfaces and a first sidewall of at least a portion of each of the channels (124), and a source/drain layer (210) on a portion of the substrate (100) adjacent to the gate structure (290) and contacting second sidewalls of the channels (124). A nitrogen-containing portion (122a) is formed at an upper portion of an uppermost one of the channels (124), and may be doped with nitrogen.

## Description

### 1. Field

Example embodiments relate to semiconductor devices. More particularly, example embodiments relate to semiconductor devices including a plurality of channels sequentially stacked in a vertical direction.

### 2. Description of the Related Art

In a method of manufacturing a semiconductor device including a plurality of channels sequentially stacked in a vertical direction, a dummy gate structure and a gate spacer may be formed on sacrificial lines and semiconductor lines alternately and repeatedly stacked in the vertical direction. An etching process is performed using the dummy gate structure and the gate spacer as an etching mask to etch the semiconductor lines and the sacrificial lines to form semiconductor patterns and sacrificial patterns, respectively. A source/drain layer is formed to contact sidewalls of the semiconductor patterns, an opening is formed through the sacrificial patterns by an etching process, and a gate structure is formed in the opening.

As the etching processes are performed, a curing process or a cleansing process is performed to cure damage to the patterns and remove an etching residue. Undesired oxide layers may be formed or some of the patterns may be removed by the curing process or the cleansing process. Accordingly, electrical insulation between some of the patterns may deteriorate, which may cause an electrical short between the patterns.

### SUMMARY

Example embodiments provide a semiconductor device having enhanced characteristics.

According to example embodiments, there is provided a semiconductor device. The semiconductor device includes channels spaced apart from each other on a substrate in a vertical direction substantially perpendicular to an upper surface of the substrate, a gate structure on the substrate and bordering lower and upper surfaces and a first sidewall of at least a portion of each of the channels, and a source/drain layer on a portion of the substrate adjacent to the gate structure and contacting second sidewalls of the channels. A nitrogen-containing portion is formed at an upper portion of an uppermost one of the channels, and is doped with nitrogen.

According to example embodiments, there is provided a semiconductor device. The semiconductor device may include channels spaced apart from each other on a substrate in a vertical direction substantially perpendicular to an upper surface of the substrate, a gate structure on the substrate and bordering lower and upper surfaces and a first sidewall of at least a portion of each of the channels, a source/drain layer on a portion of the substrate adjacent to the gate structure and contacting second sidewalls of the channels, and an oxide pattern on an upper surface of an end portion of an uppermost one of the channels and including silicon oxynitride.

According to example embodiments, there is provided a semiconductor device. The semiconductor device may include an active pattern on a substrate, channels spaced apart from each other on the active pattern in a vertical direction substantially perpendicular to an upper surface of the substrate, a gate structure on the substrate and bordering lower and upper surfaces and a first sidewall of at least a portion of each of the channels, a source/drain layer on a portion of the substrate adjacent to the gate structure and contacting second sidewalls of the channels, a gate spacer on an upper sidewall of the gate structure, a nitrogen-containing portion at an upper portion of an uppermost one of the channels, and an oxide pattern between an upper surface of each of opposite end portions of the uppermost one of the channels and a lower surface of the gate spacer.

In the semiconductor device in accordance with example embodiments, the electric insulation between the gate structure and the source/drain layer may be enhanced, so that the risk of an electric short between the gate structure and the source/drain layer may be reduced.

At least some of the above and other features of the invention are set out in the claims.

### BRIEF DESCRIPTION OF THE DRAWINGS

FIGS. 1 to 5 are a plan view and cross-sectional views illustrating a semiconductor device in accordance with example embodiments.
FIGS. 6 to 32 are plan views and cross-sectional views illustrating a method of manufacturing a semiconductor device in accordance with example embodiments.
FIG. 33 is a cross-sectional view illustrating a semiconductor device in accordance with example embodiments.
FIG. 34 is a cross-sectional view illustrating a method of manufacturing a semiconductor device in accordance with example embodiments.
FIG. 35 is a cross-sectional view illustrating a semiconductor device in accordance with example embodiments.
FIGS. 36 and 37 are cross-sectional views illustrating a method of manufacturing a semiconductor device in accordance with example embodiments.
FIGS. 38 and 39 are cross-sectional views illustrating semiconductor devices in accordance with example embodiments.

### DESCRIPTION OF EMBODIMENTS

A semiconductor device and a method of manufacturing the same in accordance with example embodiments will be described more fully hereinafter with reference to the accompanying drawings. Hereinafter in the specifications (and not necessarily in the claims), two directions among horizontal directions substantially parallel to an upper surface of a substrate, which may cross each other, may be referred to as first and second directions D1 and D2, respectively, and a vertical direction substantially perpendicular to the upper surface of the substrate may be referred to as a third direction D3. In example embodiments, the first and second directions D1 and D2 may be substantially perpendicular to each other. Like reference numerals refer to like elements throughout this application. As used herein, the term "and/or" includes any and all combinations of one or more of the associated listed items. It is noted that aspects described with respect to one embodiment may be incorporated in different embodiments although not specifically described relative thereto. That is, all embodiments and/or features of any embodiments can be combined in any way and/or combination.

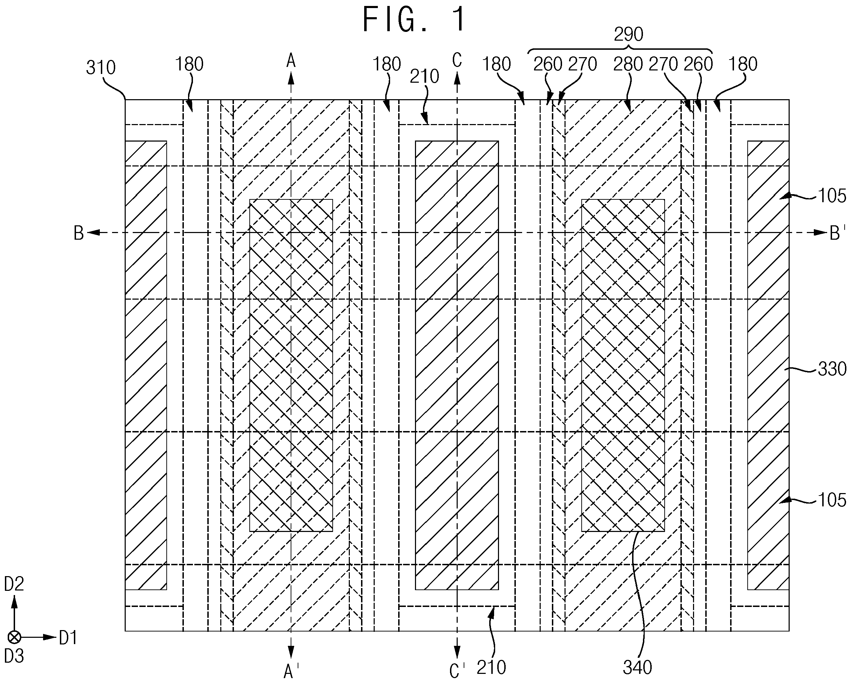

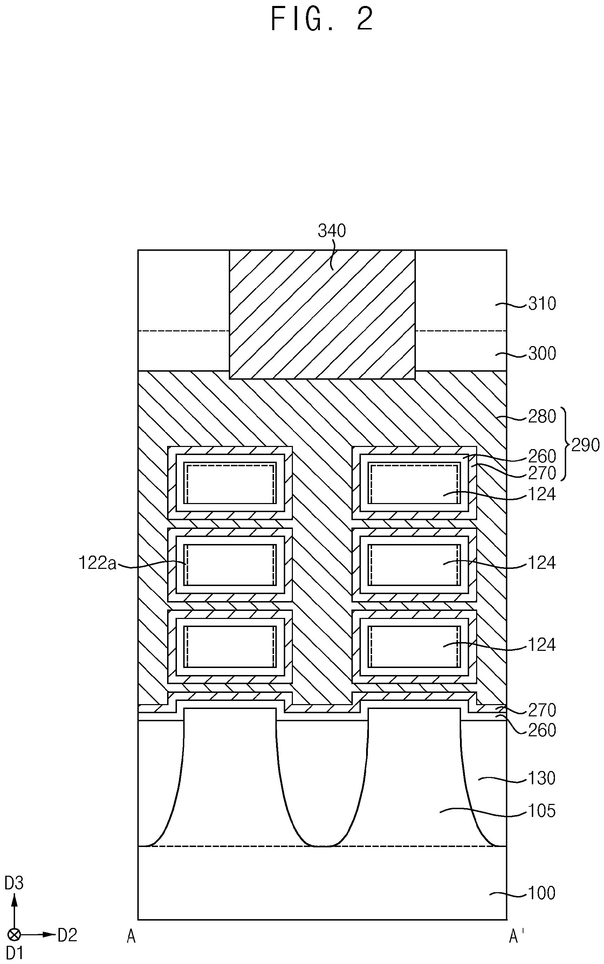

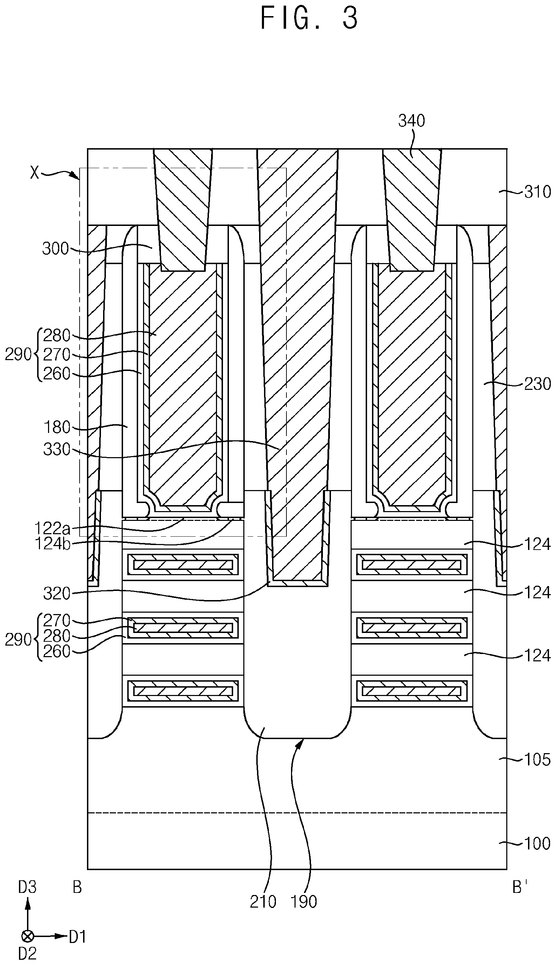

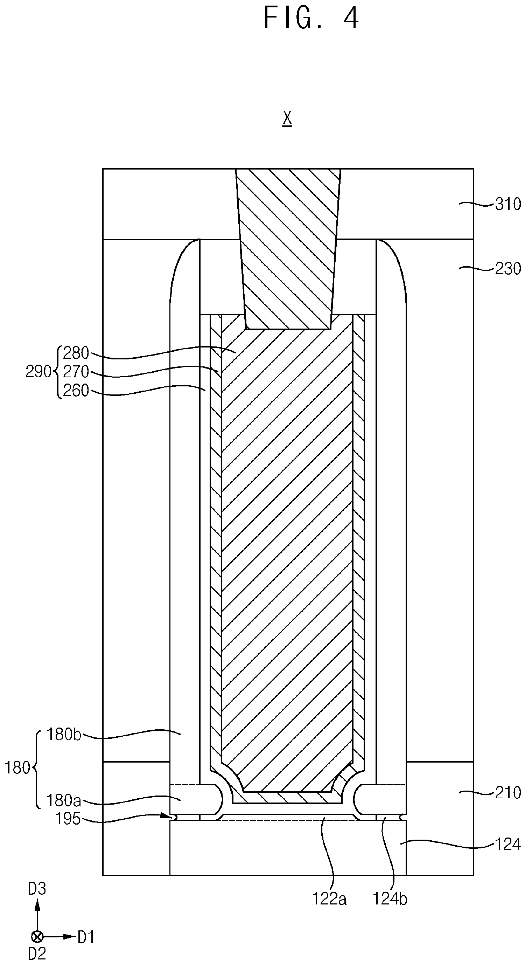

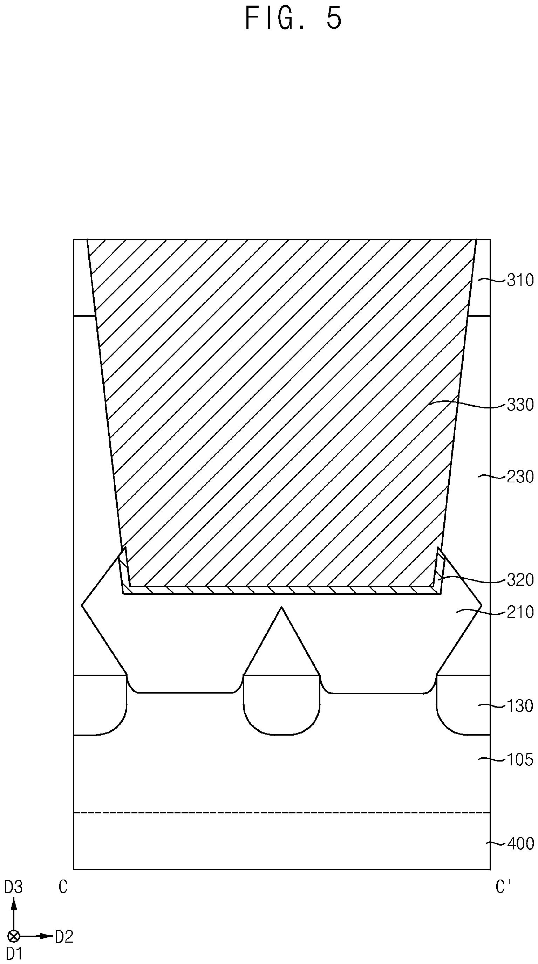

FIGS. 1 to 5 are a plan view and cross-sectional views illustrating a semiconductor device in accordance with example embodiments. In particular, FIG. 1 is the plan view, and FIGS. 2 to 5 are the cross-sectional views. FIG. 2 is a cross-sectional view taken along line A-A' of FIG. 1, FIG. 3 is a cross-sectional view taken along line B-B' of FIG. 1, and FIG. 5 is a cross-sectional view taken along line C-C' of FIG. 1. FIG. 4 is an enlarged cross-sectional view of region X of FIG. 3.

Referring to FIGS. 1 to 5, the semiconductor device may include an active pattern 105, an isolation pattern 130, semiconductor patterns 124, a second oxide pattern 124b, a gate structure 290, a gate spacer 180, a capping pattern 300, a source/drain layer 210, first and second contact plugs 330 and 340, and first and second insulating interlayers 230 and 310.

The substrate 100 may include a semiconductor material, e.g., silicon, germanium, silicon-germanium, etc., or III-V semiconductor compounds, e.g., GaP, GaAs, GaSb, etc. In some embodiments, the substrate 100 may include a silicon-on-insulator (SOI) substrate or a germanium-on-insulator (GOI) substrate.

The active pattern 105 may have a fin-like shape protruding from an upper surface of the substrate 100, and thus may also be referred to as an active fin. A sidewall of the active pattern 105 may be at least partially covered by the isolation pattern 130. The active pattern 105 may extend in the first direction D1, and a plurality of active patterns 105 may be spaced apart from each other in the second direction D2. The active pattern 105 may include a material substantially the same as that of the substrate 100, and the isolation pattern 130 may include an oxide, e.g., silicon oxide.

The semiconductor patterns 124 may be formed at a plurality of levels, respectively, that are spaced apart from each other in the third direction D3, and each of the semiconductor patterns 124 may extend in the first direction D1 to a given length. FIGS. 2 and 3 show that the semiconductor patterns 124 are formed at three levels, respectively, however, embodiments of the inventive concept may not be limited thereto.

FIG. 2 shows that two columns of semiconductor patterns 124 that are spaced apart from each other at each level (i.e., level in the D3 direction) on the active pattern 105 extending in the first direction D1, however, embodiments of the inventive concept may not be limited thereto, and a plurality of semiconductor patterns 124 may be spaced apart from each other at each level (i.e., level in the D3 direction) on the active pattern 105.

In example embodiments, the semiconductor pattern 124 may be a nano-sheet or nano-wire including a semiconductor material, e.g., silicon, germanium, etc. In example embodiments, the semiconductor pattern 124 may serve as a channel in a transistor, and thus may also be referred to as a channel.

In example embodiments, a second nitrogen-containing portion 122a may be formed at an upper portion and a lateral portion of the semiconductor pattern 124, and the second nitrogen-containing portion 122a may include silicon doped with nitrogen. A first nitrogen-containing portion will be described later.

In particular, the second nitrogen-containing portion 122a may be formed at an upper portion and opposite lateral portions in the second direction D2 of an uppermost one of the semiconductor patterns 124, and may be formed at opposite lateral portions in the second direction D2 of other ones of the semiconductor patterns 124 under the uppermost one of the semiconductor patterns 124.

In example embodiments, the second nitrogen-containing portion 122a at the upper portion of the uppermost one of the semiconductor patterns 124 may be formed at an upper portion of a central portion in the second direction D2 of the uppermost one of the semiconductor patterns 124, and may protrude in the third direction D3 upwardly when compared to edge portions in the second direction D2 of the uppermost one of the semiconductor patterns 124.

The second oxide pattern 124b may be formed on the edge portions in the second direction D2 of the uppermost one of the semiconductor patterns 124, and may be spaced apart from the second nitrogen-containing portion 122a. In example embodiments, the second oxide pattern 124b may be formed at a level in the D3 direction substantially the same as that of the second nitrogen-containing portion 122a. Thus, lower and upper surfaces of the second oxide pattern 124b may be formed at respective levels in the D3 direction substantially the same as those of lower and upper surfaces of the second nitrogen-containing portion 122a.

In example embodiments, the second oxide pattern 124b may include silicon oxide.

The gate structure 290 may extend in the second direction D2 on the active pattern 105 and the isolation pattern 130, and may include a gate insulation pattern 260, a first conductive pattern 270, and a second conductive pattern 280. The first and second conductive patterns 270 and 280 may form a gate electrode.

In example embodiments, the gate structure 290 may border and at least partially surround a central portion in the first direction D1 of each of the semiconductor patterns 124, and may be on and at least partially cover lower and upper surfaces and opposite sidewalls in the second direction D2 of the central portion of each of the semiconductor patterns 124.

In example embodiments, the second nitrogen-containing portion 122a at the upper portion of the central portion of the uppermost one of the semiconductor patterns 124 may overlap the gate structure 290 in the third direction D3, and a width in the first direction D1 of the second nitrogen-containing portion 122a may be less than a width in the first direction D1 of the gate structure 290.

In example embodiments, the gate insulation pattern 260 and the first conductive pattern 270 may be stacked on a surface of each of the semiconductor patterns 124, an upper surface of the active pattern 105, an upper surface of the isolation pattern 130, a sidewall of the source/drain layer 210, an inner sidewall of the gate spacer 180 and an inner sidewall of the second oxide pattern 124b, and the second conductive pattern 280 may be in and at least partially fill a space between the semiconductor patterns 124 spaced apart from each other in the third direction D3, a space between the active pattern 105 and a lowermost one of the semiconductor patterns 124, and a space between the gate spacers 180 spaced apart from each other in the first direction D1 on an uppermost one of the semiconductor patterns 124.

Hereinafter, a portion of the gate structure 290 on the uppermost one of the semiconductor patterns 124 in the D3 direction may be referred to as an upper portion of the gate structure 290, and other portions of the gate structure under the upper portion may be referred to as a lower portion of the gate structure 290.

The gate insulation pattern 260 may include an oxide, e.g., silicon oxide. Each of the first and second conductive patterns 270 and 280 may include a metal nitride, e.g., titanium nitride, titanium aluminum nitride, tantalum nitride, tantalum aluminum nitride, etc., a metal alloy, e.g., titanium aluminum, titanium aluminum carbide, titanium aluminum oxynitride, titanium aluminum carbonitride, titanium aluminum oxycarbonitride, etc., a metal carbide, a metal oxynitride, a metal carbonitride, a metal oxycarbonitride, and/or a low resistance metal, e.g., tungsten, aluminum, copper, tantalum. The first and second conductive patterns 270 and 280 may include substantially the same material as each other or different materials from each other.

The gate spacer 180 may be formed on each of opposite sidewalls in the first direction D1 of the gate structure 290.

In example embodiments, the gate spacer 180 may include a lower portion 180a having a relatively large width in the first direction D1 and an upper portion 180b having a relatively small width in the first direction D1. A sidewall of the lower portion 180a of the gate spacer 180 facing the gate structure 290 may be convex in the first direction D1, and a sidewall of the upper portion 180b of the gate spacer 180 facing the gate structure 290 may be substantially perpendicular to the upper surface of the substrate 100.

The second oxide pattern 124b may overlap the gate spacer 180 in the third direction D3. In example embodiments, an outer sidewall of the second oxide pattern 124b between the uppermost one of the semiconductor patterns 124 and the gate spacer 180 may be aligned with neither a sidewall of the uppermost one of the semiconductor patterns 124 nor an outer sidewall of the gate spacer 180, and may have a second recess 195 that is concave in the first direction D1.

In an example embodiment, the second oxide pattern 124b need not overlap the gate structure 290 in the third direction D3, however, embodiments of the inventive concept may not be limited thereto.

The capping pattern 300 may contact an upper surface of the gate structure 290 and the inner sidewall of the gate spacer 180.

Each of the gate spacer 180 and the capping pattern 300 may include an insulating nitride, e.g., silicon nitride.

The source/drain layer 210 may be formed on a portion of the active pattern 105 adjacent to the gate structure 290, and may commonly contact each of opposite sidewalls in the first direction D1 of the semiconductor patterns 124. In some embodiments, the source/drain layer 210 may contact the outer sidewall of the gate spacer 180.

In an example embodiment, the source/drain layer 210 may include single crystalline silicon-germanium doped with p-type impurities. Alternatively, the source/drain layer 210 may include single crystalline silicon doped with n-type impurities or single crystalline silicon carbide doped with n-type impurities.

In example embodiments, the source/drain layer 210 may contact the outer sidewall of the second oxide pattern 124b on each of opposite end portions in the first direction D1 of the uppermost one of the semiconductor patterns 124. The second oxide pattern 124b may include the second recess 195 on the outer sidewall thereof that may be concave from the sidewall of the uppermost one of the semiconductor patterns 124 and the outer sidewall of the gate spacer 180, and thus a portion of the source/drain layer 210 contacting the second oxide pattern 124b may protrude in the first direction D1 toward the gate structure 290 from other portions thereof.

The first insulating interlayer 230 may be formed on the substrate 100, and may at least partially cover an upper surface of the source/drain layer 210 and the outer sidewall of the gate spacer 180. The second insulating interlayer 310 may be formed on the first insulating interlayer 230, the capping pattern 300, and the gate spacer 180.

Each of the first and second insulating interlayers 230 and 310 may include an insulating material, e.g., silicon oxycarbide, silicon oxide, silicon nitride, silicon oxynitride, silicon carbonitride, and/or silicon oxycarbonitride, etc.

The first contact plug 330 may extend through the first and second insulating interlayers 230 and 310 and an upper portion of the source/drain layer 210 to be electrically connected thereto. An ohmic contact pattern 320 may be formed between the first contact plug 330 and the source/drain layer 210.

The second contact plug 340 may extend through the second insulating interlayer 310 and the capping pattern 300, and may contact the second conductive pattern 280 included in the gate electrode.

Each of the first and second contact plugs 330 and 340 may include, e.g., a metal, a metal nitride, etc., the ohmic contact pattern 320 may include a metal silicide, e.g., cobalt silicide, nickel silicide, titanium silicide, etc.

Upper wirings may be formed on the first and second contact plugs 330 and 340 to apply electric signals thereto.

The semiconductor device may be a multi-bridge channel field effect transistor (MBCFET) including the semiconductor patterns 124 spaced apart from each other in the third direction D3 and serving as channels, respectively.

In the semiconductor device, the gate spacer 180 may be formed between the upper portion of the gate structure 290 and the source/drain layer 210, and the second oxide pattern 124b between the uppermost one of the semiconductor patterns 124 and the gate spacer 180 may also be formed between the upper portion of the gate structure 290 and the source/drain layer 210. Thus, the upper portion of the gate structure 290 and the source/drain layer 210 may be electrically insulated from each other by the gate spacer 180 and the second oxide pattern 124b, and the risk of an electrical short between the gate structure 290 and the source/drain layer 210 may be reduced or prevented.

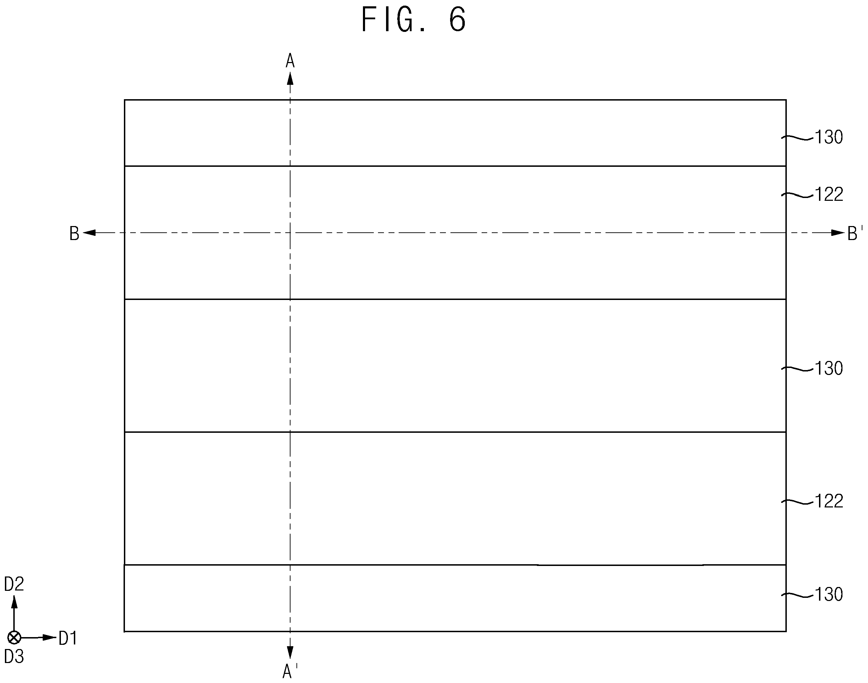

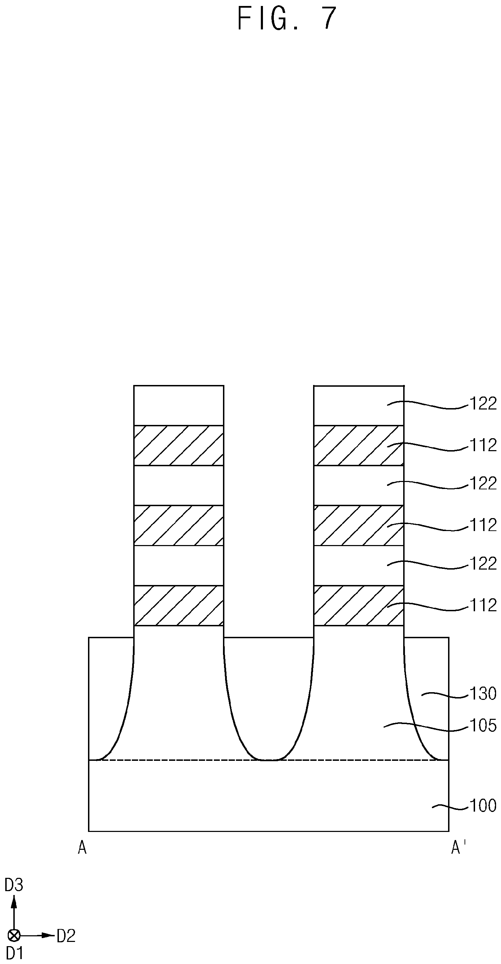

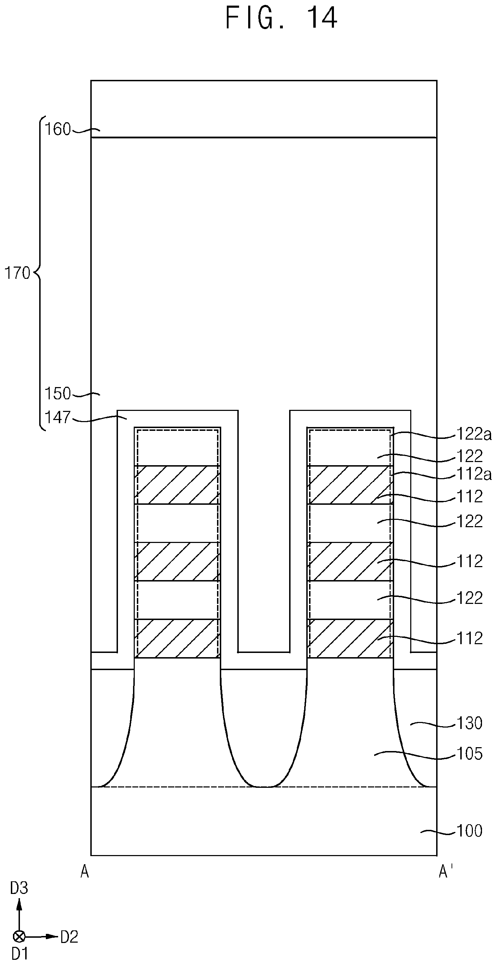

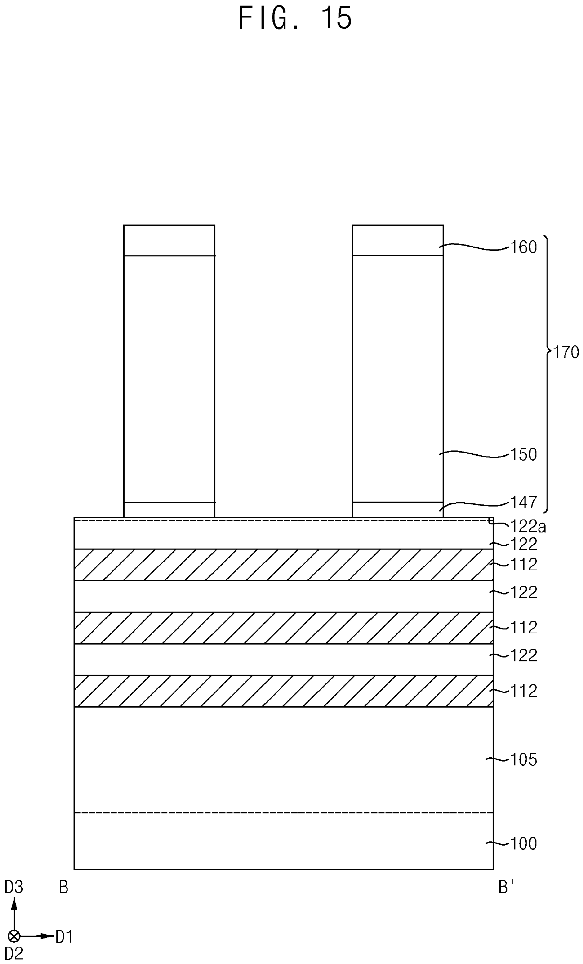

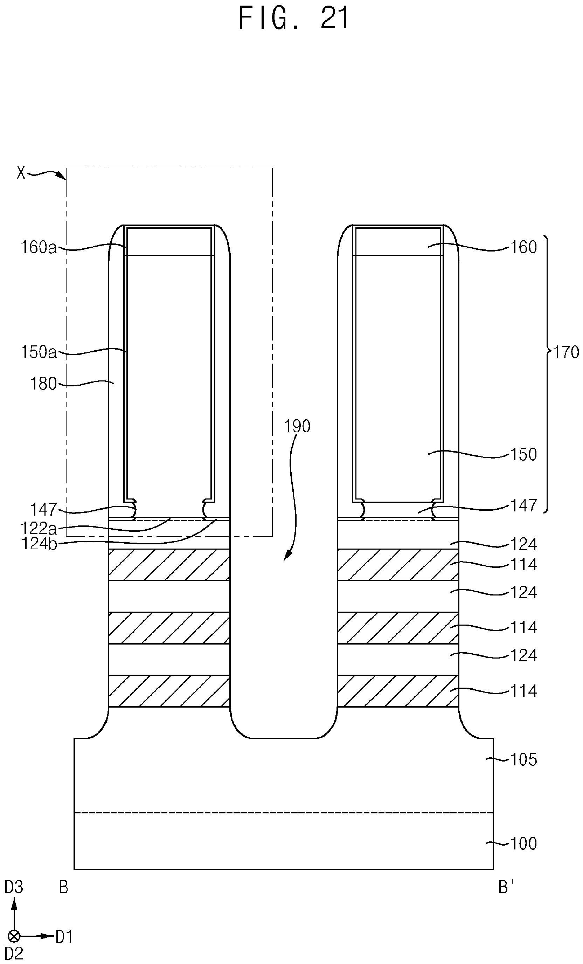

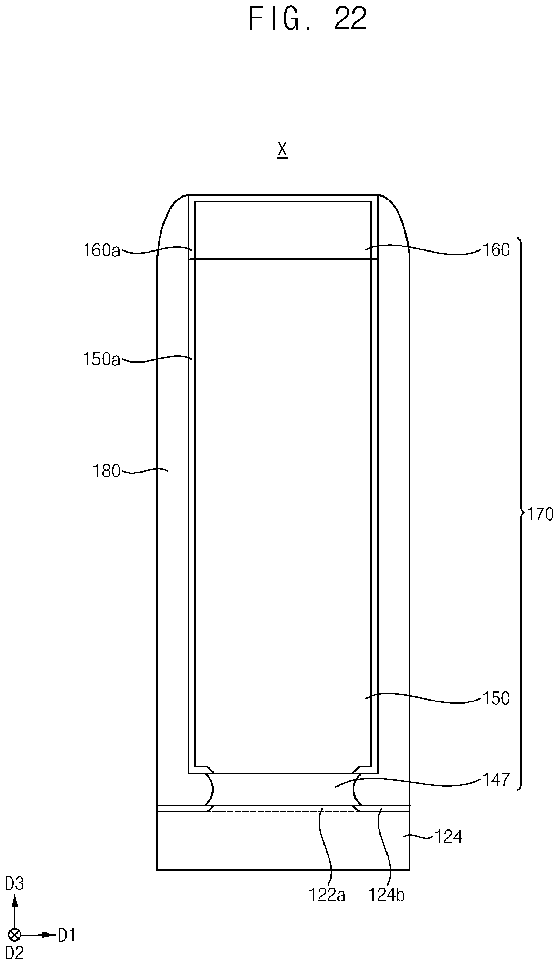

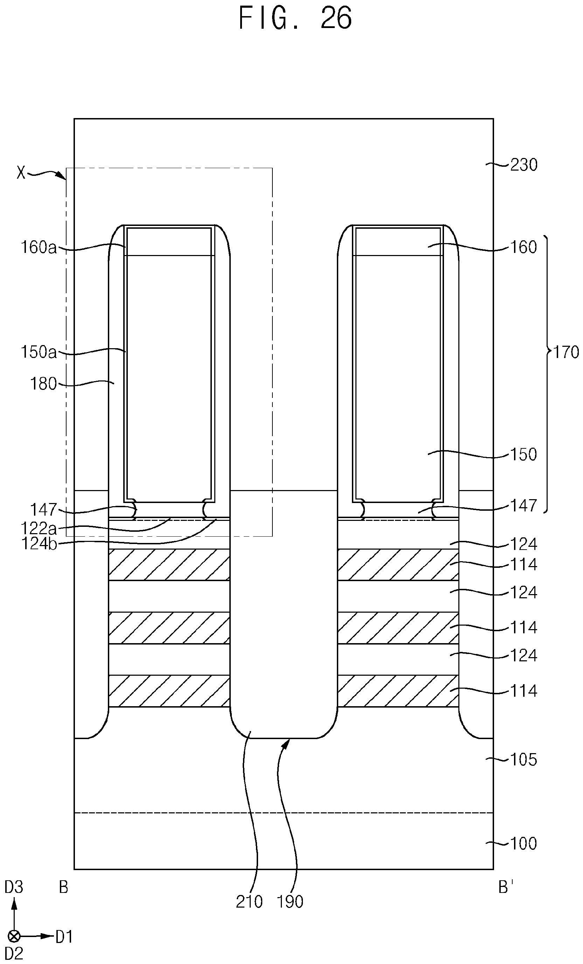

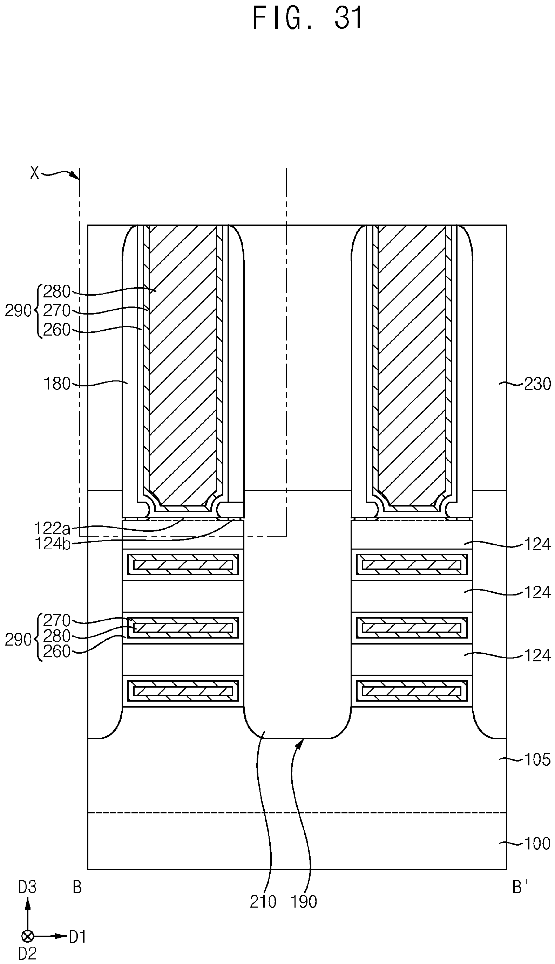

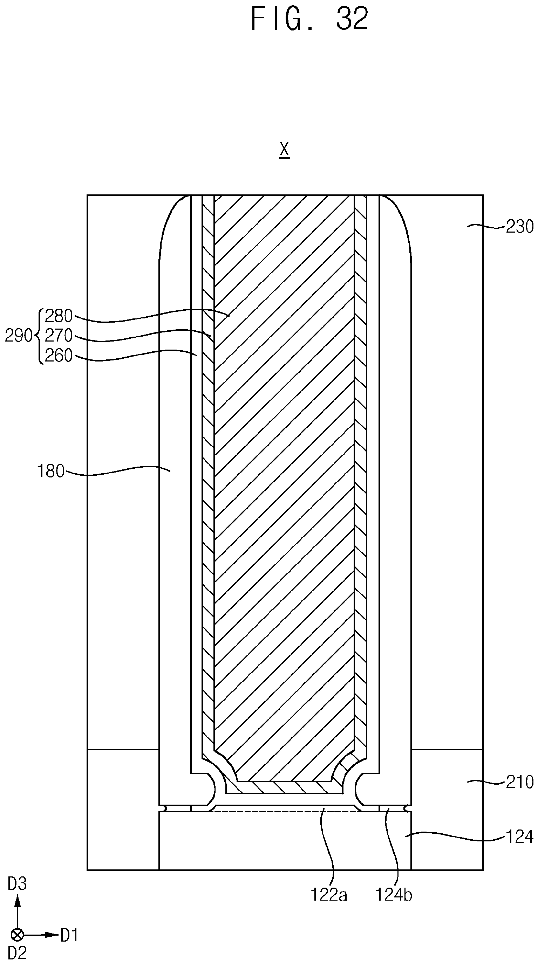

FIGS. 6 to 32 are plan views and cross-sectional views illustrating a method of manufacturing a semiconductor device in accordance with example embodiments. Particularly, FIGS. 6, 13, 20, 25 and 30 are the plan views, and FIGS. 7-12, 14-19, 21-24, 26-29 and 31-32 are the cross-sectional views.

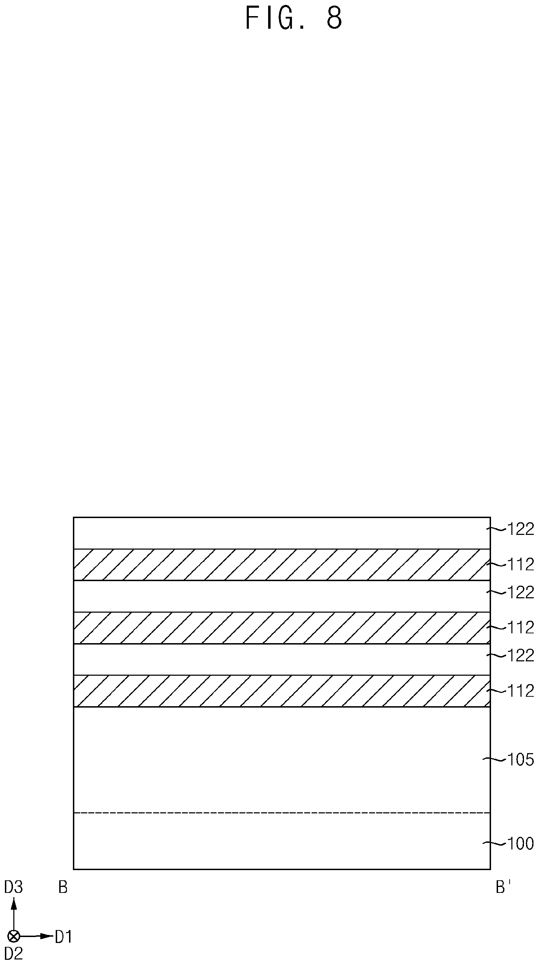

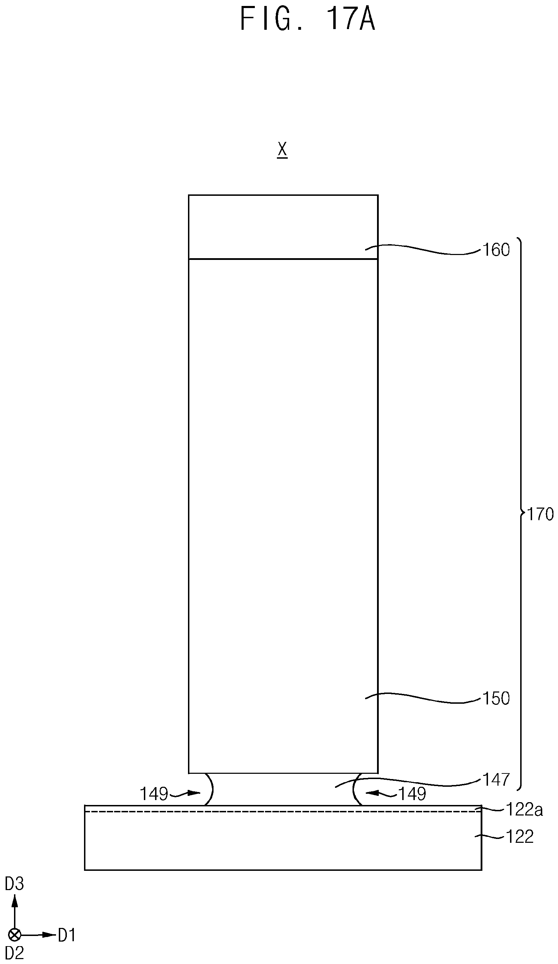

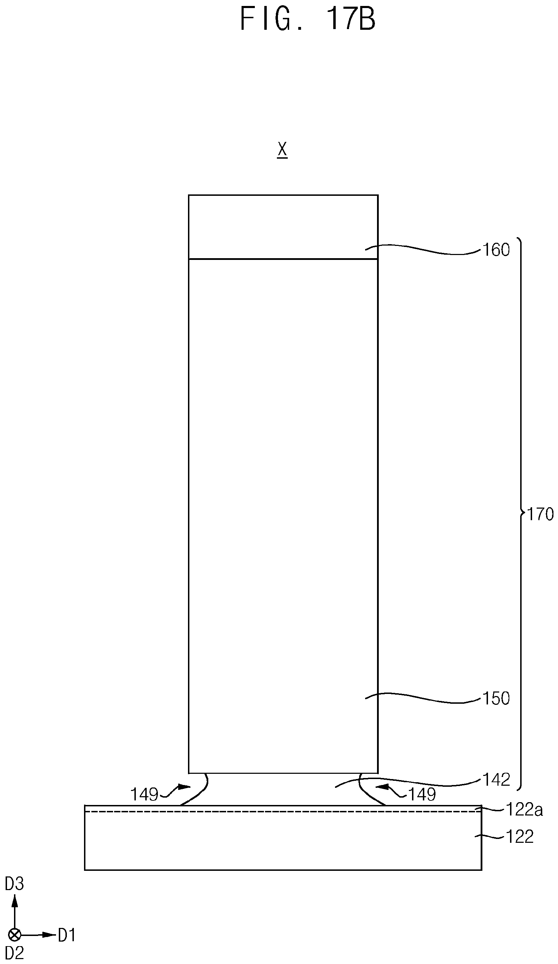

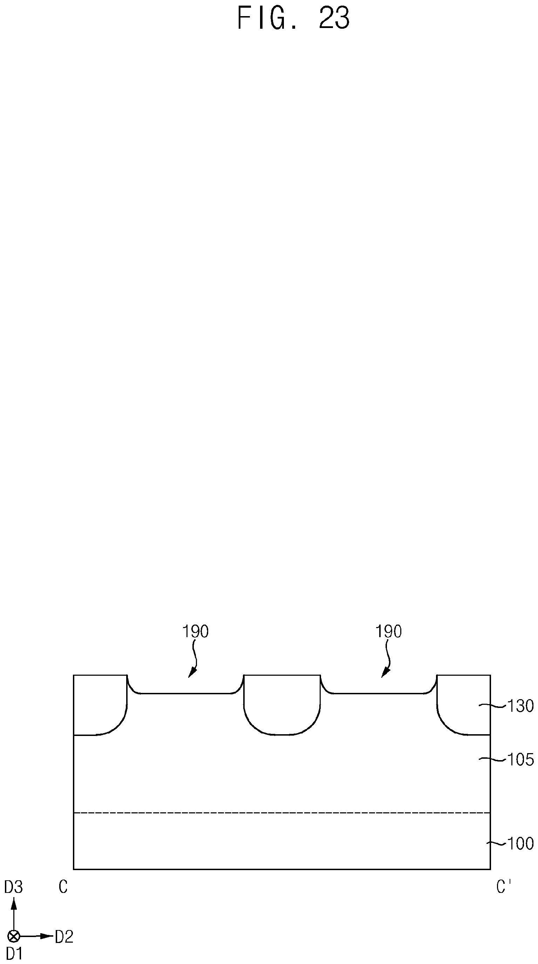

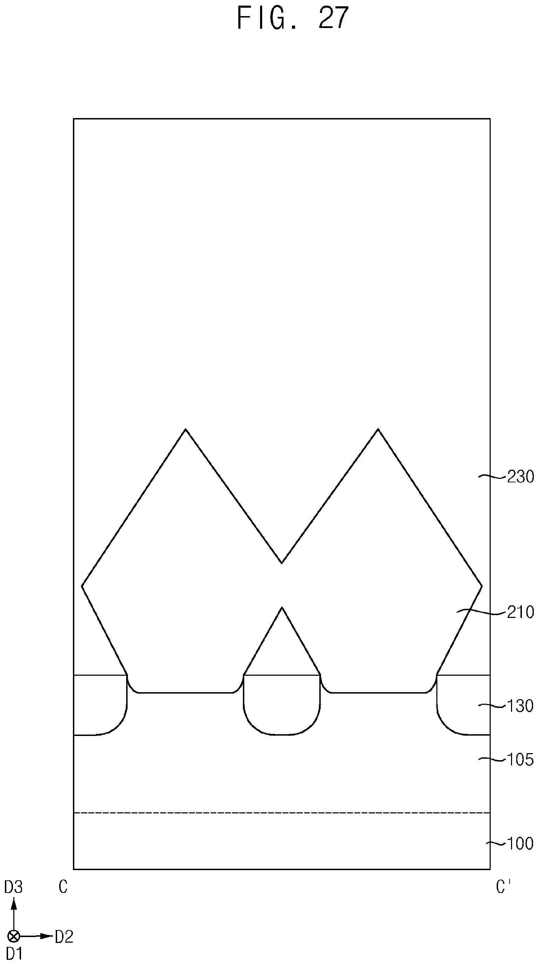

FIGS. 7, 9, 11 and 14 are cross-sectional views taken along lines A-A' of corresponding plan views, respectively, FIGS. 8, 10, 12, 15-19, 21-22, 24, 26, 28-29 and 31-32 are cross-sectional views taken along lines B-B' of corresponding plan views, respectively, and FIG. 23 and 27 are cross-sectional views taken along line C-C' of corresponding plan views, respectively. FIGS. 17, 19, 22, 24, 29 and 32 are enlarged cross-sectional views of the region X of corresponding plan views, respectively.

Referring to FIGS. 6 to 8, a sacrificial layer and a semiconductor layer may be alternately and repeatedly stacked on a substrate 100, a first etching mask extending in the first direction D1 may be formed on an uppermost one of the semiconductor layers, and the semiconductor layers, the sacrificial layers and an upper portion of the substrate 100 may be etched using the first etching mask.

Thus, an active pattern 105 extending in the first direction D1 may be formed on the substrate 100, and a fin structure including sacrificial lines 112 and semiconductor lines 122 alternately and repeatedly stacked in the third direction D3 may be formed on the active pattern 105. In example embodiments, the fin structure may extend in the first direction D1 on the substrate 100, and a plurality of fin structures may be spaced apart from each other in the second direction D2 on the substrate 100.

FIG. 7 shows three sacrificial lines 112 and three semiconductor lines 122 at three levels in the D3 direction, respectively, however, embodiments of the inventive concept may not be limited thereto. The sacrificial lines 112 may include a material having an etching selectivity with respect to the substrate 100 and the semiconductor lines 122, e.g., silicon-germanium.

An isolation pattern 130 may be formed on the substrate 100 to at least partially cover a sidewall of the active pattern 105.

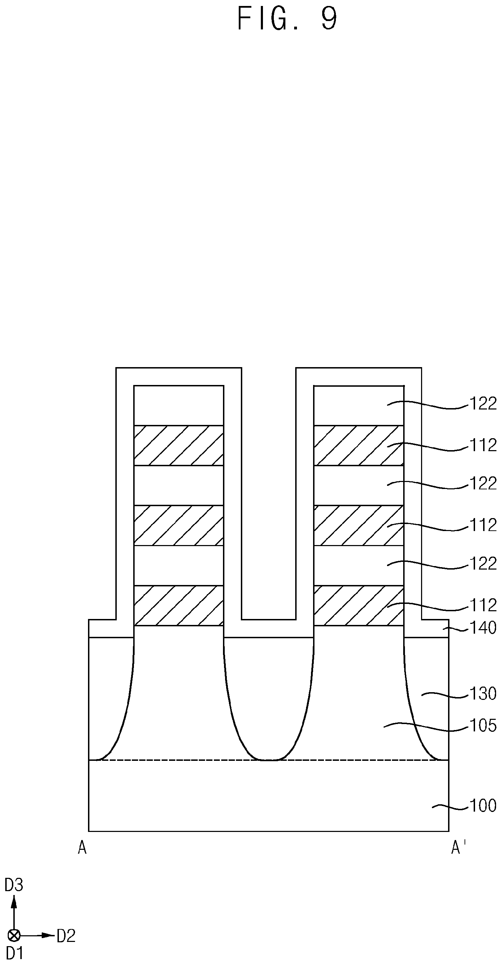

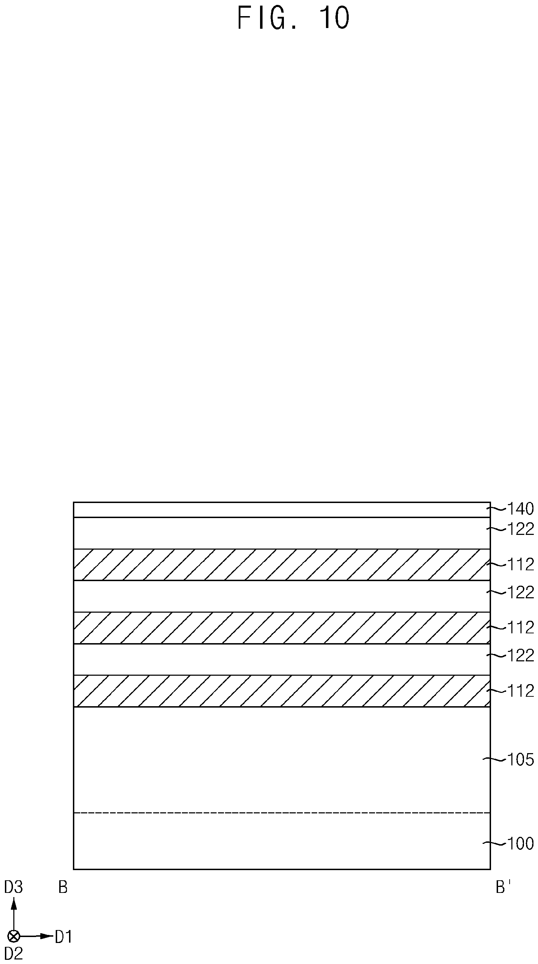

Referring to FIGS. 9 and 10, a dummy gate insulation layer 140 may be formed on the substrate 100 to at least partially cover the fin structure and the isolation pattern 130.

The dummy gate insulation layer 140 may include an oxide, e.g., silicon oxide.

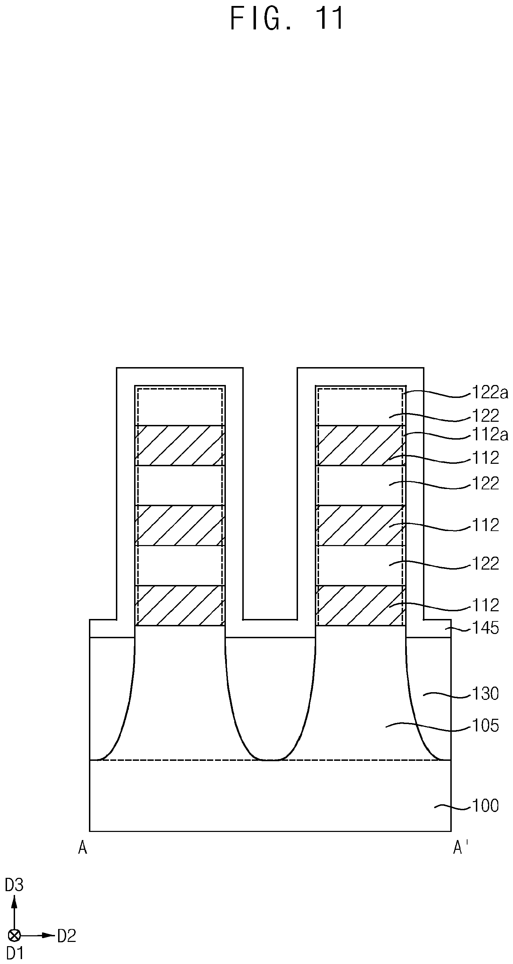

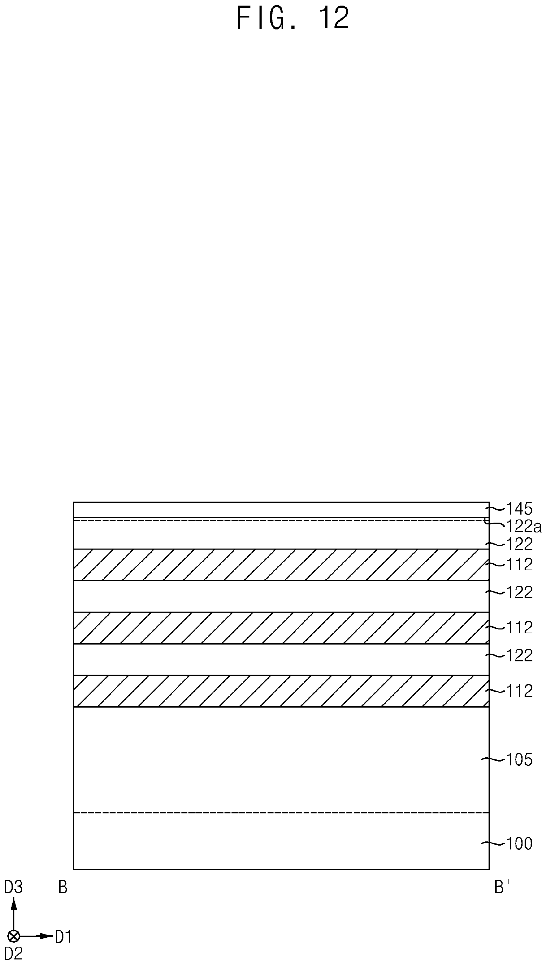

Referring to FIGS. 11 and 12, a nitridation process, e.g., a plasma nitridation process may be performed on the dummy gate insulation layer 140.

Thus, the dummy gate insulation layer 140 may be converted into a sacrificial gate insulation layer 145 include an insulating nitride, e.g., silicon oxynitride.

During the nitridation process, nitrogen may permeate into and remain at an upper surface and a sidewall of the semiconductor line 122 and a sidewall of the sacrificial line 112. Thus, a second nitrogen-containing portion 122a including silicon doped with nitrogen may be formed at the upper surface and the sidewall in the second direction D2 of the semiconductor line 122, and a first nitrogen-containing portion 112a including silicon-germanium doped with nitrogen may be formed at the sidewall in the second direction D2 of the sacrificial line 112.

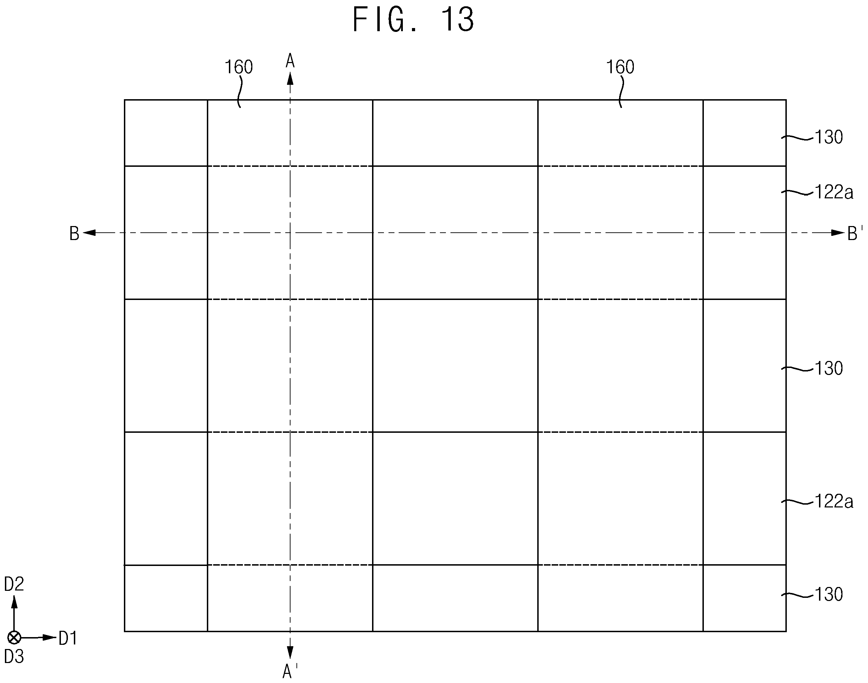

Referring to FIGS. 13 to 15, a dummy gate electrode layer and a dummy gate mask layer may be sequentially formed on the sacrificial gate insulation layer 145, a second etching mask extending in the second direction D2 may be formed on the dummy gate mask layer, and the dummy gate mask layer may be etched using the second etching mask to form a dummy gate mask 160.

The dummy gate electrode layer and the sacrificial gate insulation layer 145 may be etched using the dummy gate mask 160 as an etching mask to form a dummy gate electrode 150 and a sacrificial gate insulation pattern 147, respectively, on the substrate 100.

The sacrificial gate insulation pattern 47, the dummy gate electrode 150 and the dummy gate mask 160 sequentially stacked in the third direction D3 on the active pattern 105 and a portion of the isolation pattern 130 adjacent thereto may form a dummy gate structure 170. In example embodiments, the dummy gate structure 170 may extend in the second direction D2 on the fin structure and the isolation pattern 130, and may be on and at least partially cover an upper surface and opposite sidewalls in the second direction D2 of the fin structure.

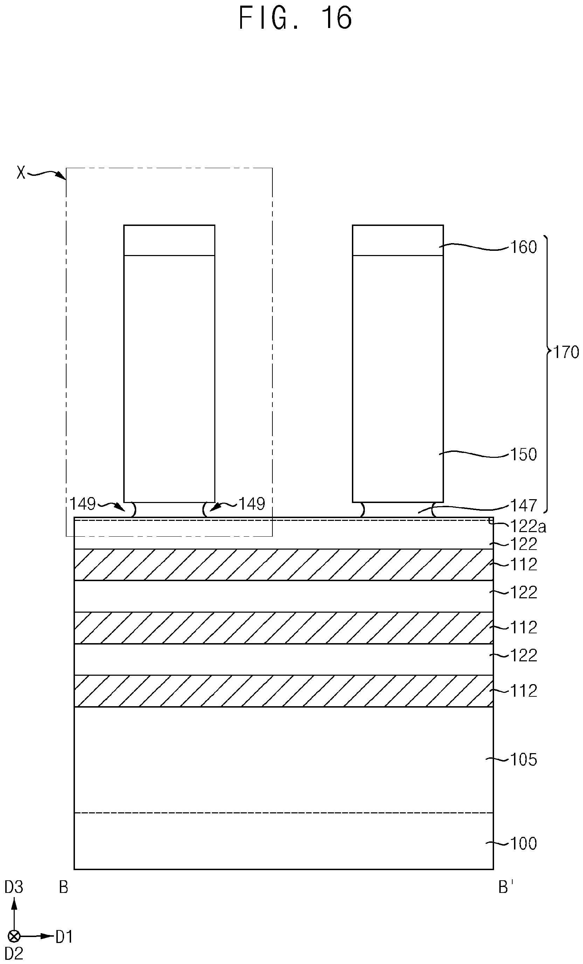

Referring to FIGS. 16 and 17A, a portion of the sacrificial gate insulation pattern 147 under an edge portion of the dummy gate electrode 150 may be removed by an etching process to form a first recess 149 on a sidewall of the sacrificial gate insulation pattern 147 under the dummy gate electrode 150.

The sacrificial gate insulation pattern 147 may include, e.g., silicon oxynitride, and thus an etch rate of the sacrificial gate insulation pattern 146 may be relatively low when compared to a layer including, e.g., silicon oxide. Thus, an amount of a portion of the sacrificial gate insulation pattern 147 removed during the etching process may be relatively easily controlled.

In example embodiments, during the etching process, lower and upper portions of the sacrificial gate insulation pattern 147 may be etched by substantially the same amount, and thus the sacrificial gate insulation pattern 147 remaining after the etching process may be generally symmetric in the third direction D3 with reference to an imaginary plane passing a central portion in the third direction D3 of the sacrificial gate insulation pattern 147. Additionally, the sacrificial gate insulation pattern 147 after the etching process need not protrude toward an outside of the dummy gate electrode 150 in a plan view, and may be formed only in an area of the dummy gate electrode 150 in a plan view.

Referring to FIG. 17B, if the nitridation process illustrated with reference to FIGS. 11 and 12 is not performed, a dummy gate insulation pattern 142 that may be formed by patterning the dummy gate insulation layer 140 may include silicon oxide. Thus, during the etching process, an etch rate of the dummy gate insulation pattern 142 may be high so that an amount of a portion of the dummy gate insulation pattern 142 removed during the etching process may be difficult to control.

Accordingly, during the etching process, lower and upper portions of the dummy gate insulation pattern 142 need not be etched by the same amount, and for example, the lower portion may be etched less than the upper portion so that the dummy gate insulation pattern 142 remaining after the etching process may not be symmetric in the third direction D3. Additionally, the dummy gate insulation pattern 142 after the etching process may protrude toward the outside of the dummy gate electrode 150 to be formed at the outside of the dummy gate electrode 150 in a plan view.

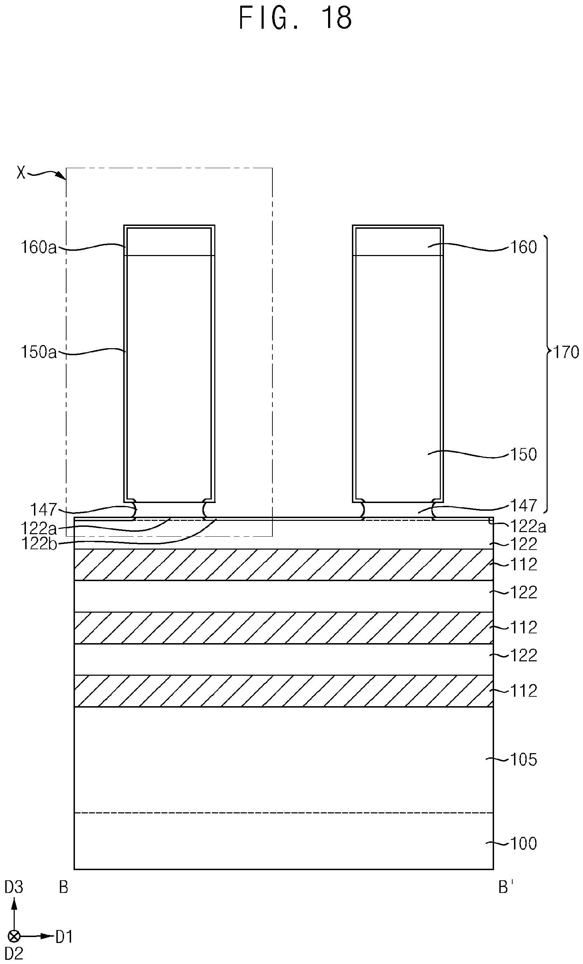

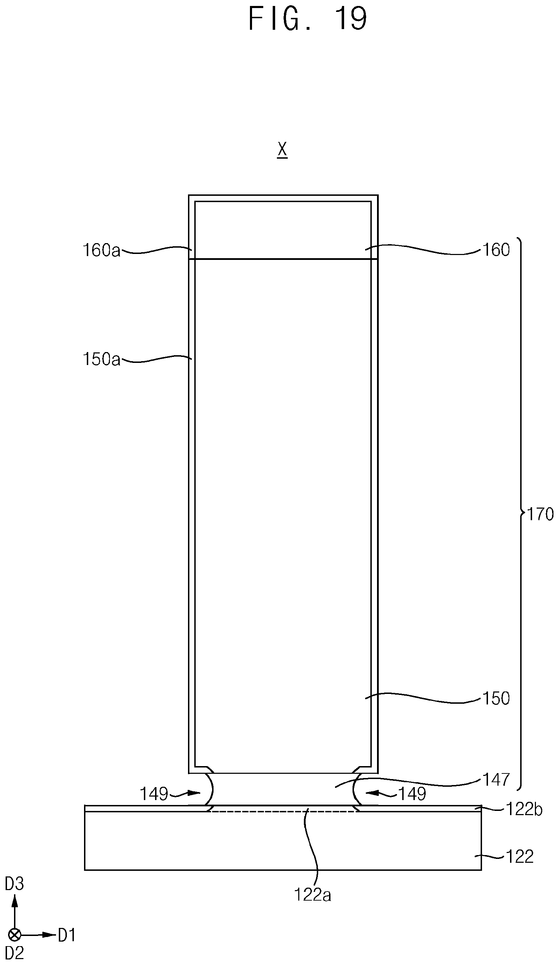

Referring to FIGS. 18 and 19, a curing process may be performed on surfaces of the fin structure and the dummy gate structure 170, which may be damaged during the etching process for forming the dummy gate structure 170.

In example embodiments, the curing process may be performed using, e.g., HF and SC1 solution, and the surfaces of the fin structure and the dummy gate structure 170 may be oxidized by oxygen included in the SC1 solution.

Thus, a portion of the second nitrogen-containing portion 122a at the upper surface and the sidewall of the semiconductor line 122, which may include silicon doped with nitrogen, particularly, a portion of the second nitrogen-containing portion 122a not covered by the sacrificial gate insulation pattern 147 may be converted into a second oxide layer 122b including silicon oxynitride. Additionally, a portion of the first nitrogen-containing portion 112a at the sidewall of the sacrificial line 112, which may include silicon-germanium doped with nitrogen, may be converted into a first oxide layer (not shown).

A third oxide layer 150a may be formed at a sidewall of the dummy gate electrode 150 including, e.g., polysilicon may be formed to include silicon oxide, a fourth oxide layer 160a may be formed at an upper surface, and a sidewall of the dummy gate mask 160 may be formed to include silicon oxynitride.

However, an additional oxide layer need not be formed on a sidewall of the sacrificial gate insulation pattern 147 including silicon oxynitride, and a volume of the sacrificial gate insulation pattern 147 may slightly increase. Thus, a portion of the second oxide layer 122b that may be formed by the curing process may partially contact an edge portion of the sacrificial gate insulation pattern 147.

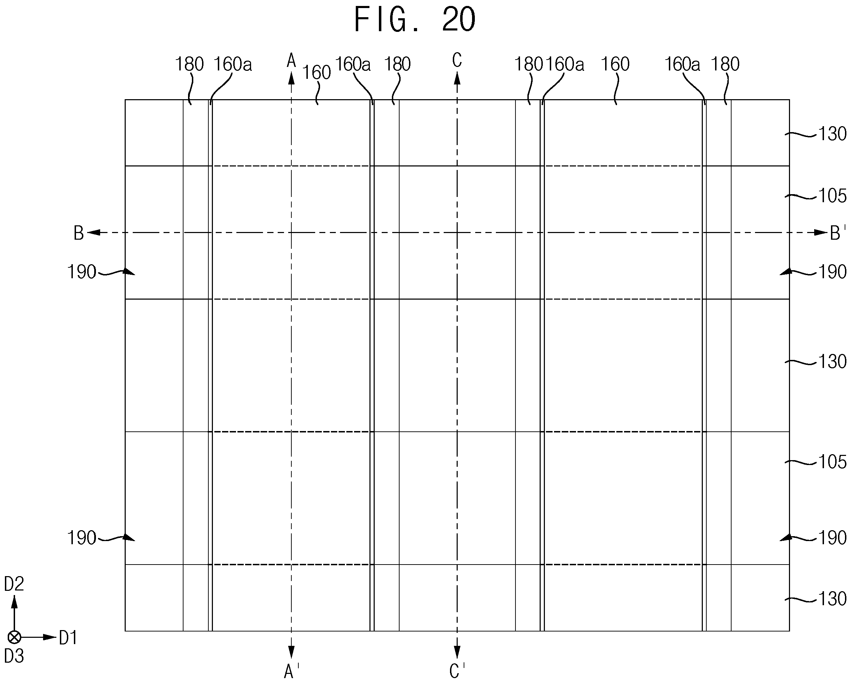

Referring to FIGS. 20 to 23, a gate spacer 180 may be formed on the sidewall of the dummy gate structure 170.

Particularly, a spacer layer may be formed on the substrate 100 having the fin structure, the isolation pattern 130 and the dummy gate structure 170 and may not be anisotropically etched to form the gate spacer 180 on each of opposite sidewalls in the first direction D1 of the dummy gate structure 170.

During the anisotropic etching process, a portion of the fourth oxide layer 160a on the upper surface of the dummy gate mask 160 may be removed.

The fin structure and an upper portion of the active pattern may be etched using the dummy gate structure 170 and the gate spacer 180 as an etching mask to form a first opening 190.

Thus, the sacrificial lines 112 and the semiconductor lines 122 under the dummy gate structure 170 and the gate spacers 180 may be transformed into sacrificial patterns 114 and semiconductor patterns 124, respectively, and the fin structure extending in the first direction D1 may be divided into a plurality of parts spaced apart from each other in the first direction D1.

During the etching process, the first oxide layer and the second oxide layer 122b may also be partially etched to form a first oxide pattern (not shown) and a second oxide pattern 124b.

Hereinafter, the dummy gate structure 170, the gate spacer 180 on each of opposite sidewalls of the dummy gate structure 170 and the fin structure may be referred to as a stack structure. In example embodiments, the stack structure may extend in the second direction D2, and a plurality of stack structures may be spaced apart from each other in the first direction D1.

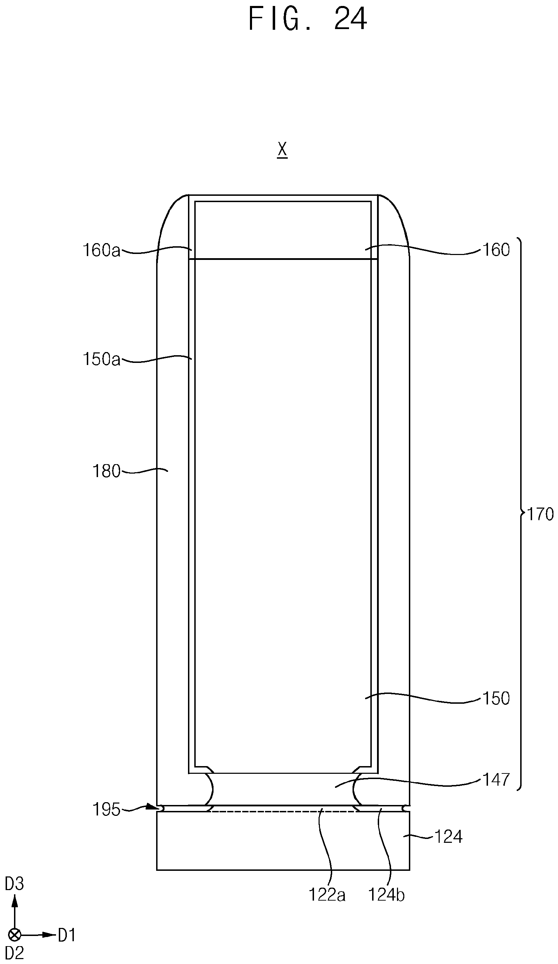

Referring to FIG. 24, a cleansing process may be performed on the substrate 100 having the stack structure thereon.

By the cleansing process, a lateral portion of the second oxide pattern 124b exposed by the first opening 190 may be removed to form a second recess 195.

As illustrated above, the second oxide pattern 124b may include, e.g., silicon oxynitride, and thus the amount of the portion of the second oxide pattern 124b removed during the cleansing process may be relatively small when compared to a layer including, e.g., silicon oxide. Thus, the second recess 195 on the outer sidewall of the second oxide pattern 124b may be formed, for example, only in an area of the gate spacer 180 in a plan view, and need not overlap the dummy gate structure 170 in the third direction D3.

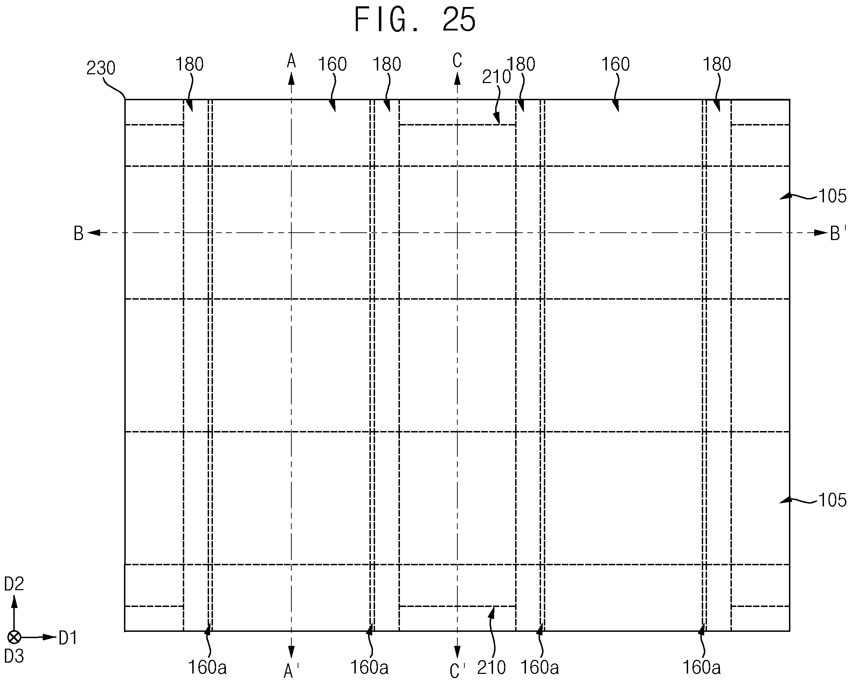

Referring to FIGS. 25 to 27, a selective epitaxial growth (SEG) process may be performed using the upper surface of the active pattern 105 and the sidewalls of the semiconductor patterns 124 and the sacrificial patterns 114 exposed by the first openings 190 as a seed to a source/drain layer 210 in the first opening 190.

In an example embodiment, the SEG process may be performed using a silicon source gas, e.g., dichlorosilane (SiH₂Cl₂) gas, a germanium source gas, e.g., germane (GeH₄) gas, and thus a single crystalline silicon-germanium layer may be formed as the second source/drain layer 210. A p-type impurity source gas, e.g., diborane (B₂H₆) gas may also be used so that a single crystalline silicon-germanium layer doped with p-type impurities may be formed as the second source/drain layer 210.

In another example embodiment, the SEG process may be performed using a silicon source gas, e.g., disilane (Si₂H₆) gas and a carbon source gas, e.g., SiH₃CH₃, and thus a single crystalline silicon carbide layer may be formed as the first source/drain layer 210. An n-type impurity source gas, e.g., PH₃, POCl₃, P₂O₅, etc., may also be used so that a single crystalline silicon carbide layer doped with n-type impurities may be formed as the first source/drain layer 210. In other embodiments, the SEG process may be performed using the silicon source gas and the impurity source gas so that a single crystalline silicon layer doped with n-type impurities may be formed as the first source/drain layer 210.

A first insulating interlayer 230 may be formed on the substrate 100 to be on and at least partially cover the stack structure and the source/drain layer 210.

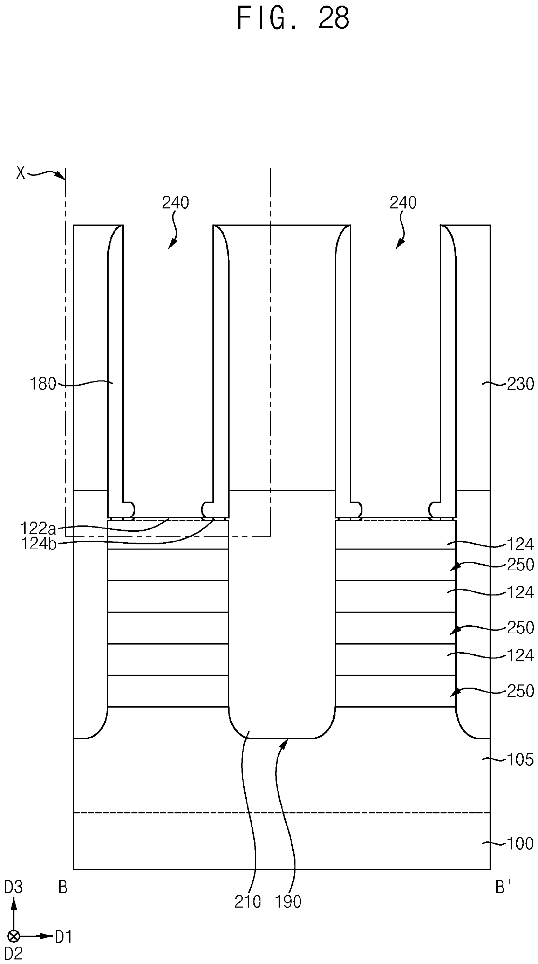

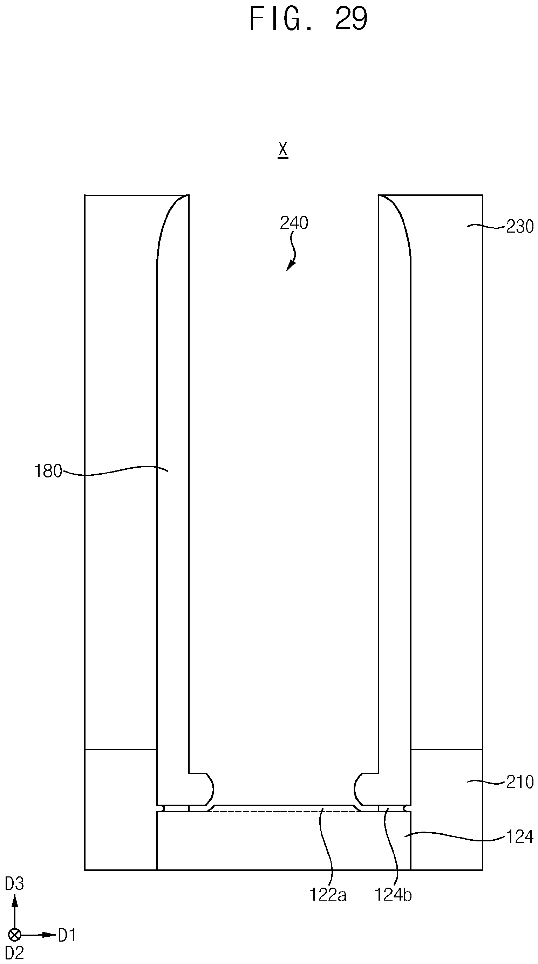

Referring to FIGS. 28 and 29, a planarization process may be performed until an upper surface of the dummy gate electrode 150 included in the stack structure is exposed so that an upper portion of the first insulating interlayer 230 and the dummy gate mask 160 included in the dummy gate structure 170 may be removed. During the planarization process, the fourth oxide layer 160a on the sidewall of the dummy gate mask 160 may also be removed.

The dummy gate electrode 150, the sacrificial gate insulation pattern 147 and the sacrificial patterns 114 may be removed by, e.g., by using a wet etching process and/or a dry etching process, and the third oxide layer 150a on the sidewall of the dummy gate electrode 150 and a portion of the second oxide pattern 124b contacting the sacrificial gate insulation pattern 147 may also be removed.

However, in example embodiments, the second oxide pattern 124b need not be entirely removed, and for example, a portion of the second oxide pattern 124b not overlapping the dummy gate electrode 150 in the third direction D3 may remain.

Thus, a second opening 240 exposing an inner sidewall of the gate spacer 180 and an upper surface of an uppermost one of the semiconductor patterns 124, and a third opening 250 exposing a sidewall of the third source/drain layer 210, surfaces of the semiconductor patterns 124, and an upper surface of the active pattern 105 may be formed. Additionally, a surface of the second nitrogen-containing portion 122a at the upper surface and the sidewall of the semiconductor pattern 124 and a sidewall of the second oxide pattern 124b may be exposed by the second opening 240.

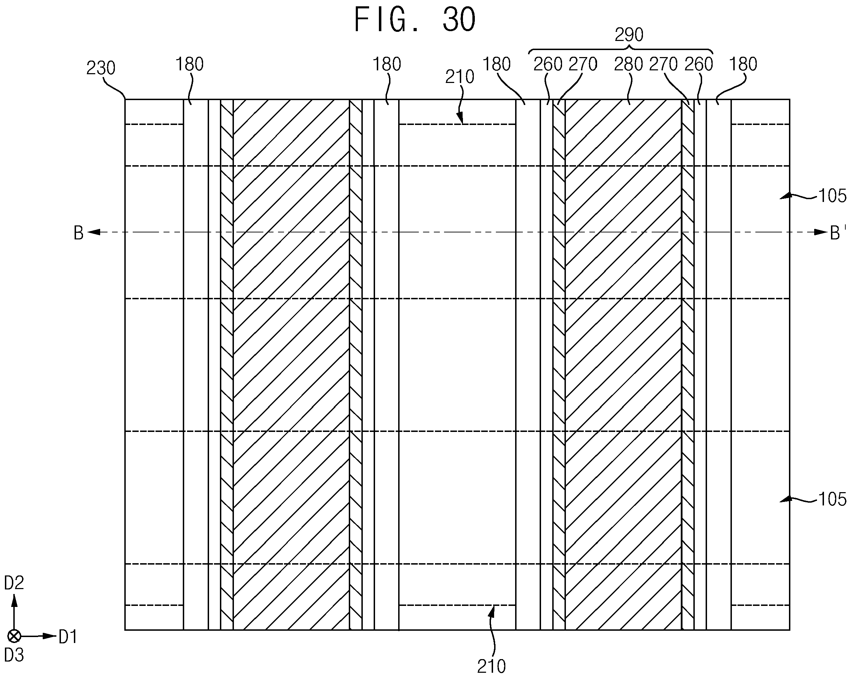

Referring to FIGS. 30 to 32, a gate insulation layer and a first conductive layer may be sequentially stacked on the inner sidewall of the gate spacer 180, the surfaces of the semiconductor patterns 124, the sidewall of the second oxide pattern 124b, the upper surface of the active pattern 105, the upper surface of the isolation pattern 130, and the sidewall of the source/drain layer 120 exposed by the second and third openings 240 and 250. An upper surface of the first insulating interlayer 230 and a second conductive layer may be formed on the first conductive layer to at least partially fill remaining portions of the second and third openings 240 and 250.

In an example embodiment, an interface pattern including, e.g., silicon oxide may be further formed on the upper surface of the active pattern 105 and the surfaces of the semiconductor patterns 124.

The first and second conductive layers and the gate insulation layer may be planarized until the upper surface of the first insulating interlayer is exposed. Thus, a gate structure 290 at least partially filling the second and third openings 240 and 250 and including a gate insulation pattern 260, a first conductive pattern 270, and a second conductive pattern 280 may be formed. The first and second conductive patterns 270 and 280 may form a gate electrode.

Referring to FIGS. 1 to 5, an upper portion of the gate structure 290 may be removed to form a third recess, and a capping pattern 300 may be formed in the third recess.

A second insulating interlayer 310 may be formed on the capping pattern 300, the gate spacer 180, and the first insulating interlayer 230. A first contact plug 330 extending through the first and second insulating interlayers 230 and 310 and an upper portion of the source/drain layer 210 and a second contact plug 340 extending through the second insulating interlayer 310 and the capping pattern 300 to contact an upper surface of the second conductive pattern 280 may be formed.

In an example embodiment, an ohmic contact pattern 320 may be further formed between the first contact plug 330 and the source/drain layer 210.

Upper wirings may be further formed on the first and second contact plugs 330 and 340 to complete the fabrication of the semiconductor device.

As illustrated above, after forming the dummy gate insulation layer 140 including, e.g., silicon oxide on the fin structure including the sacrificial line 112 and the semiconductor line 122 alternately stacked on the active pattern 105, a nitridation process may be performed on the dummy gate insulation layer 140 to form the sacrificial gate insulation layer 145 including, e.g., silicon oxynitride, and the second nitrogen-containing portion 122a including silicon doped with nitrogen may be formed at the upper portion of the semiconductor line 122.

During the formation of the dummy gate structure 170, the sacrificial gate insulation layer 145 may be patterned to form the sacrificial gate insulation pattern 147, and the lateral portion of the sacrificial gate insulation pattern 147 may be further etched by an additional etching process to form the first recess 149. The sacrificial gate insulation layer 145 may include, e.g., silicon oxynitride instead of silicon oxide, and thus the etch rate of the sacrificial gate insulation pattern 147 may be relatively low during the additional etching process, so that the amount of the portion of the sacrificial gate insulation pattern 147 removed by the additional etching process may be relatively easily controlled, and that the sacrificial gate insulation pattern 147 may be formed only in the area of the dummy gate electrode 150 in a plan view.

The curing process may be performed on the fin structure and the dummy gate structure 170 using, e.g., HF and SC1 solution, and the portion of the second nitrogen-containing portion 122a not covered by the sacrificial gate insulation pattern 147 may be converted by oxygen included in the SC1 solution into the second oxide layer 122b including silicon oxynitride, while the volume of the sacrificial gate insulation pattern 147 including oxygen may barely increase.

After forming the gate spacer 180 on the sidewall of the dummy gate structure 170, the fin structure and the upper portion of the active pattern 105 may be etched by an etching process using the dummy gate structure 170 and the gate spacer 180 as an etching mask to form the first opening 190, and the sacrificial line 112 and the semiconductor line 122 may be transformed into the sacrificial pattern 114 and the semiconductor pattern 124, respectively, and the second oxide layer 122b may be transformed into the second oxide pattern 124b.

During the cleansing process, the second oxide pattern 124b exposed by the first opening 190 may be partially removed, however, only a small amount of the second oxide pattern 124b might be removed when compared to a layer including silicon oxide.

After forming the source/drain layer 210 in the first opening 190, when the dummy gate structure 170 and the sacrificial pattern 114 are removed to form the second and third openings 240 and 250, the second oxide pattern 124b adjacent to the sacrificial gate insulation pattern 147 may also be partially removed, but may not be entirely removed.

Thus, when the gate structure 290 is formed in the second and third openings 240 and 250, not only the gate spacer 180 but also the second oxide pattern 124b may be formed between a portion of the gate structure 290 in the second opening 240, that is, the upper portion of the gate structure 290 on the uppermost one of the semiconductor patterns 124 and the source/drain layer 210, so that the risk of an electrical short between the gate structure 290 and the source/drain layer 210 may be reduced or prevented.

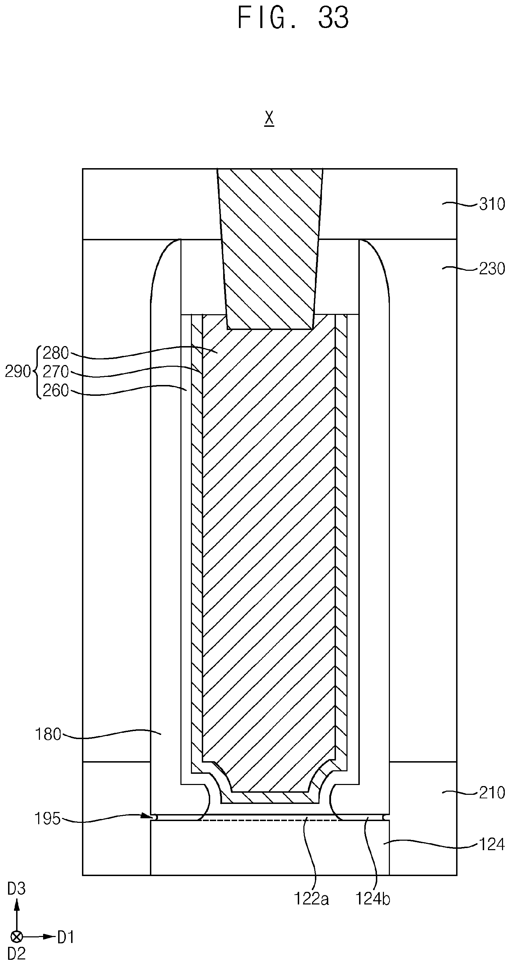

FIG. 33 is a cross-sectional view illustrating a semiconductor device in accordance with example embodiments, and may correspond to FIG. 4.

This semiconductor device may be substantially the same as or similar to that of FIGS. 1 to 5, except for the second oxide pattern 124b and the gate insulation pattern 260, and thus repeated explanations thereof are omitted herein.

Referring to FIG. 33, the second oxide pattern 124b may not be spaced apart from but may contact the second nitrogen-containing portion 122a.

Thus, the gate insulation pattern 260 need not be interposed between the second oxide pattern 124b and the second nitrogen-containing portion 122a, and need not contact a sidewall of the second nitrogen-containing portion 122a and an inner sidewall of the second oxide pattern 124b.

In an example embodiment, a portion of the second oxide pattern 124b may overlap the gate structure 290 in the third direction D3.

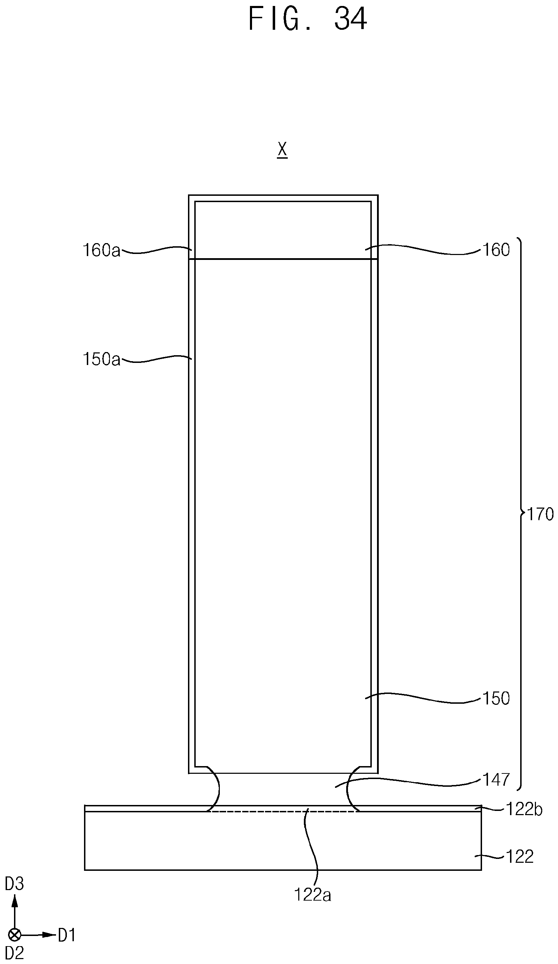

FIG. 34 is a cross-sectional view illustrating a method of manufacturing a semiconductor device in accordance with example embodiments, and may correspond to FIG. 19.

This method may include processes substantially the same as or similar to those illustrated with reference to FIGS. 6 to 32 and FIGS. 1 to 5, and thus repeated explanations thereof are omitted herein.

Referring to FIG. 34, processes substantially the same as or similar to those illustrated with reference to FIGS. 1 to 19 may be performed.

However, after the curing process, the second oxide layer 122b on each of opposite end portions of the uppermost one of the semiconductor patterns 124 may not contact an edge portion of the sacrificial gate insulation pattern 147.

Processes substantially the same as or similar to those illustrated with reference to FIGS. 20 to 29 may be performed, however. During the formation of the second opening 240, the second oxide pattern 124b need not contact the sacrificial gate insulation pattern 147, and thus no portion of the second oxide pattern 124b need be removed.

Processes substantially the same as or similar to those illustrated with reference to FIGS. 30 to 32 and FIGS. 1 to 5 may be performed to complete the fabrication of the semiconductor device.

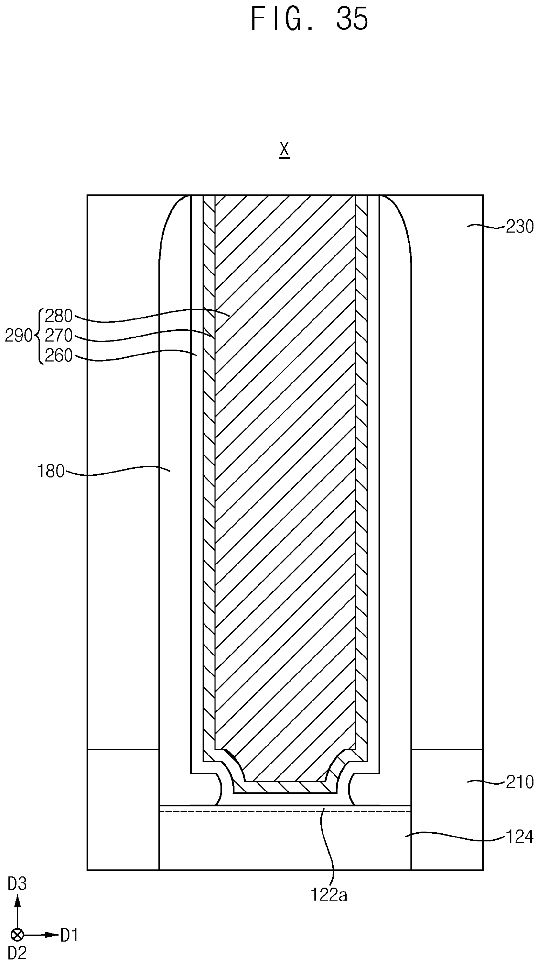

FIG. 35 is a cross-sectional view illustrating a semiconductor device in accordance with example embodiments, and may correspond to FIG. 4.

This semiconductor device may be substantially the same as or similar to that of FIGS. 1 to 5, except for the second nitrogen-containing portion 122a, the second oxide pattern 124b, and the gate insulation pattern 260, and thus repeated explanations thereof are omitted herein.

Referring to FIG. 35, the second nitrogen-containing portion 122a at the upper portion of the uppermost one of the semiconductor patterns 124 may be formed not only at the central portion in the first direction D1 but also at the edge portions in the first direction D1, and thus the second oxide pattern 124b need not be formed.

The second nitrogen-containing portion 122a may include silicon doped with nitrogen, and thus need not be removed during the cleansing process or the formation of the second and third openings 240 and 250 for forming the gate structure 290. Accordingly, the electrical insulation between the gate structure 290 and the source/drain layer 210 may be acquired.

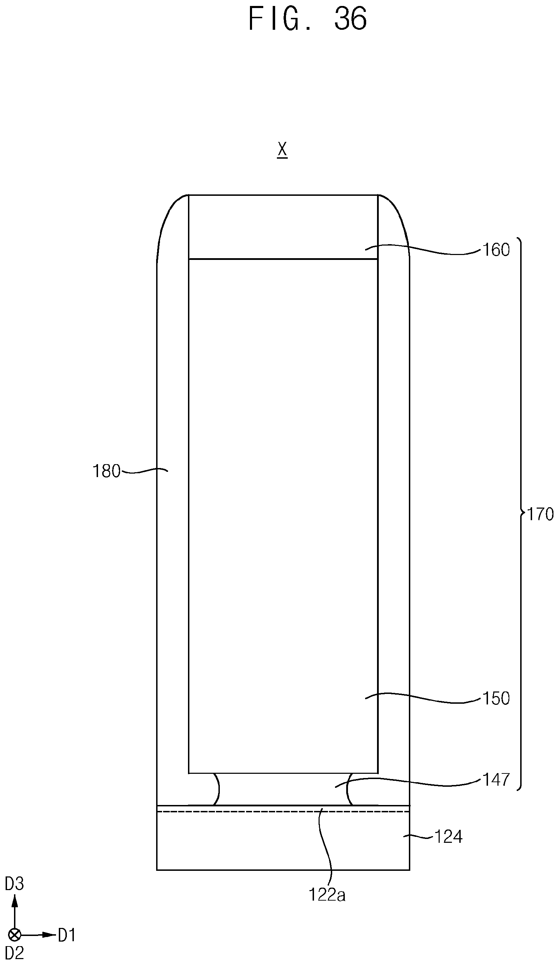

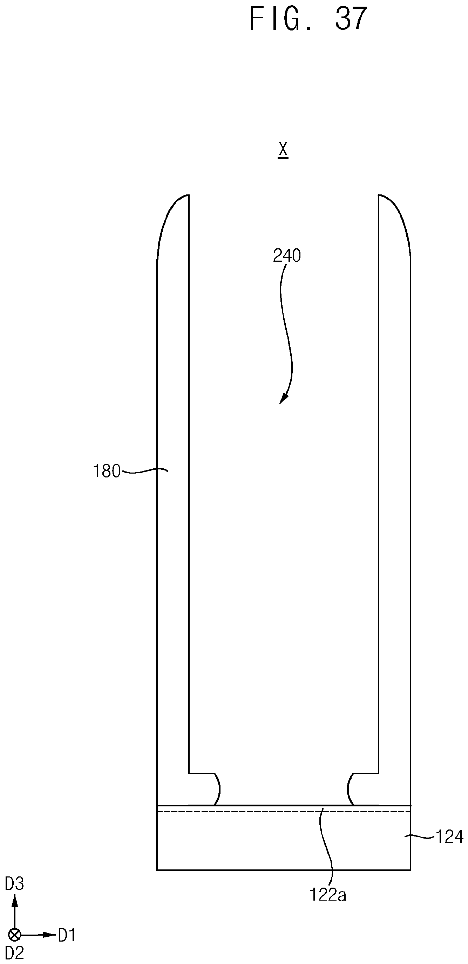

FIGS. 36 and 37 are cross-sectional views illustrating a method of manufacturing a semiconductor device in accordance with example embodiments, and may correspond to FIGS. 24 and 29, respectively.

This method may include processes substantially the same as or similar to those illustrated with reference to FIGS. 6 to 32 and FIGS. 1 to 5, and thus repeated explanations thereof are omitted herein.

Processes substantially the same as or similar to those illustrated with reference to FIGS. 1 to 17 may be performed.

The curing process illustrated with reference to FIGS. 18 and 19 need not be performed. Thus, the end portions of the second nitrogen-containing portion 122a at the upper portion of the uppermost one of the semiconductor patterns 124 need not be converted into the second oxide layer 122b.

Referring to FIG. 36, processes substantially the same as or similar to those illustrated with reference to FIGS. 20 to 24 may be performed.

However, instead of the second oxide pattern 124b including, e.g., silicon oxynitride, the second nitrogen-containing portion 122a including silicon doped with nitrogen may be formed at the end portions of the uppermost one of the semiconductor patterns 124, so that the second recess 195 need not be formed when the cleansing process is performed.

Referring to FIG. 37, processes substantially the same as or similar to those illustrated with reference to FIGS. 25 to 29 may be performed.

However, the second nitrogen-containing portion 122a contacting the sacrificial gate insulation pattern 147 may include silicon doped with nitrogen so as not to be removed when the sacrificial gate insulation pattern 147 is removed to form the second opening 240.

Referring to FIG. 35, processes substantially the same as or similar to those illustrated with reference to FIGS. 30 to 32 and FIGS. 1 to 5 may be performed to complete the fabrication of the semiconductor device.

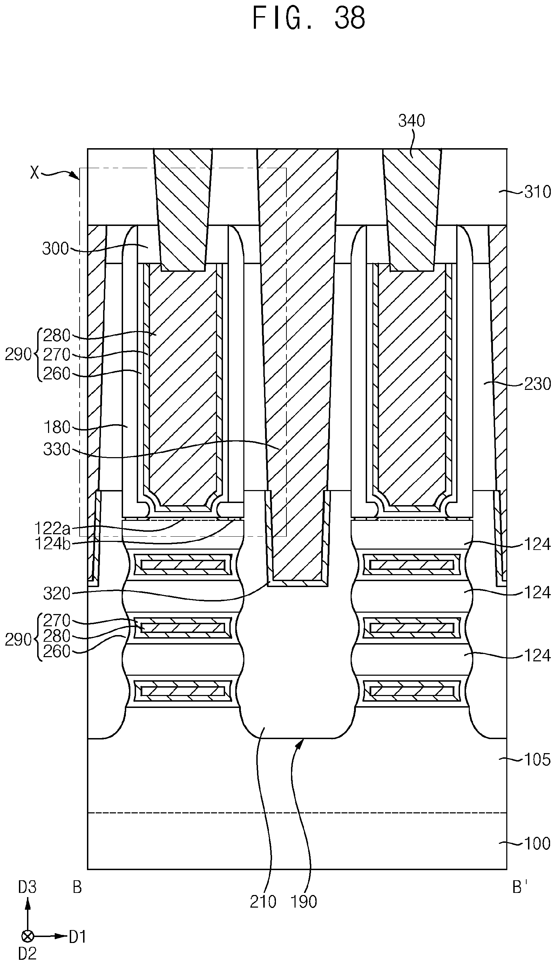

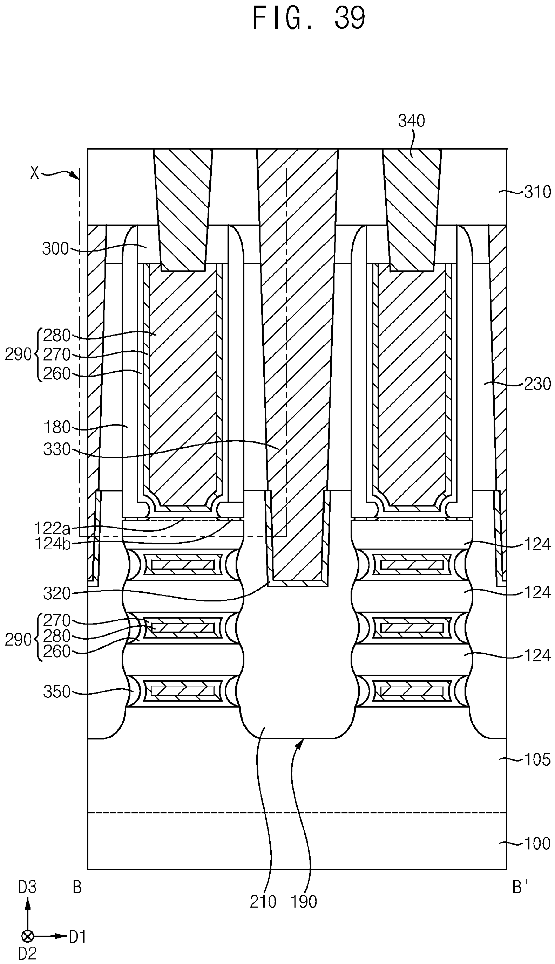

FIGS. 38 and 39 are cross-sectional views illustrating semiconductor devices in accordance with example embodiments, and may correspond to FIG. 3.

These semiconductor devices may be substantially the same as or similar to that of FIGS. 1 to 5, except for the shape of the source/drain layer 210 or further including an inner spacer, and thus repeated explanations thereof are omitted herein.

Referring to FIG. 38, a sidewall in the first direction D1 of the source/drain layer 210 may not be substantially perpendicular to the upper surface of the substrate 100, but may have varying slopes with respect to the upper surface of the substrate 100.

The sidewall of the source/drain layer 210 may have a width in the first direction D1 that may change in the third direction D3. In some embodiments, the width may periodically change in the third direction D3. Thus, the sidewall of the source/drain layer 210 may have concave portions and convex portions in the first direction D1 that may be alternately and repeatedly stacked in the third direction D3. In example embodiments, a width of the source/drain layer 210 facing the semiconductor pattern 124 may be less than a width of the source/drain layer 210 facing the lower portion of the gate structure 290.

Referring to FIG. 39, an inner spacer 350 may be formed between the source/drain layer 210 and the lower portion of the gate structure 290.

In an example embodiment, the inner spacer 350 may have a convex shape toward the gate structure 290. The inner spacer 350 may include an insulating nitride, e.g., silicon nitride.

The foregoing is illustrative of example embodiments and is not to be construed as limiting thereof. Although a few example embodiments have been described, those skilled in the art will readily appreciate that many modifications are possible in the example embodiments without materially departing from the novel teachings and advantages of the present inventive concept. Accordingly, all such modifications are intended to be included within the scope of the present inventive concept as defined in the claims. In the claims, means-plus-function clauses are intended to cover the structures described herein as performing the recited function and not only structural equivalents but also equivalent structures. Therefore, it is to be understood that the foregoing is illustrative of various example embodiments and is not to be construed as limited to the specific example embodiments disclosed, and that modifications to the disclosed example embodiments, as well as other example embodiments, are intended to be included within the scope of the appended claims.

## Claims

1. A semiconductor device, comprising:
channels spaced apart from each other on a substrate in a vertical direction substantially perpendicular to an upper surface of the substrate;
a gate structure on the substrate, the gate structure bordering lower and upper surfaces and a first sidewall of at least a portion of each of the channels; and
a source/drain layer on a portion of the substrate adjacent to the gate structure, the source/drain layer contacting second sidewalls of the channels,
wherein a nitrogen-containing portion is formed at an upper portion of an uppermost one of the channels, the nitrogen-containing portion being doped with nitrogen.

2. The semiconductor device as claimed in claim 1, wherein the nitrogen-containing portion protrudes from other portions of the uppermost one of the channels in the vertical direction.

3. The semiconductor device as claimed in claim 1 or 2, wherein each of the channels extends in a first direction substantially parallel to the upper surface of the substrate, and
wherein the nitrogen-containing portion is formed at an upper portion of a central portion in the first direction of the uppermost one of the channels.

4. The semiconductor device as claimed in claim 3, further comprising an oxide pattern on an upper surface of each of opposite end portions in the first direction of the uppermost one of the channels, the oxide pattern including silicon oxynitride.

5. The semiconductor device as claimed in claim 4, wherein the oxide pattern is formed at substantially a same level in the vertical direction as that of the nitrogen-containing portion.

6. The semiconductor device as claimed in claim 4 or 5, wherein a portion of the gate structure is interposed between the nitrogen-containing portion and the oxide pattern.

7. The semiconductor device as claimed in claim 4, 5 or 6, wherein the nitrogen-containing portion and the oxide pattern contact each other.

8. The semiconductor device as claimed in any one of claims 1 to 7, wherein each of the channels extends in a first direction substantially parallel to the upper surface of the substrate, and the gate structure extends in a second direction substantially parallel to the upper surface of the substrate and crossing the first direction, and
wherein the nitrogen-containing portion is formed at each of opposite sidewalls in the second direction of each of the channels.

9. The semiconductor device as claimed in any one of claims 1 to 8, wherein:
the gate structure includes:
a lower portion being lower than an upper surface of the uppermost one of the channels in the vertical direction; and
an upper portion on the lower portion,
the semiconductor device further comprises a gate spacer on a sidewall of the upper portion of the gate structure, and
the gate spacer includes:
a lower portion having a first width; and
an upper portion having a second width less than the first width.

10. The semiconductor device as claimed in claim 9, wherein the lower portion of the gate spacer has a convex shape that extends toward the gate structure.

11. The semiconductor device as claimed in any one preceding claim, comprising:
an active pattern on a substrate;
a gate spacer on an upper sidewall of the gate structure; and
an oxide pattern between an upper surface of each of opposite end portions of the uppermost one of the channels and a lower surface of the gate spacer.

12. The semiconductor device as claimed in claim 11, wherein the nitrogen-containing portion includes silicon doped with nitrogen, and the oxide pattern includes silicon oxynitride.

13. The semiconductor device as claimed in claim 11 or 12, wherein:
the active pattern extends in a first direction substantially parallel to the upper surface of the substrate, and the gate structure extends in a second direction substantially parallel to the upper surface of the substrate and crossing the first direction,
the gate spacer is formed at each of opposite sidewalls in the first direction of the gate structure, and
the nitrogen-containing portion is formed at an upper portion of a central portion in the first direction of the uppermost one of the channels, and the oxide pattern is formed on an upper surface of each of opposite end portions in the first direction of the uppermost one of the channels.

14. The semiconductor device as claimed in claim 13, wherein the oxide pattern does not overlap the gate structure in the vertical direction.

15. The semiconductor device as claimed in claim 13 or 14, wherein a portion of the oxide pattern overlaps the gate structure in the vertical direction.
